# EUROPÄISCHE PATENTSCHRIFT

(11) **EP 2 272 108 B1**
(45) Veröffentlichungstag und Bekanntmachung des Hinweises auf die Patenterteilung: **28.11.2018**
(21) Anmeldenummer: 09737881.4
(22) Anmeldetag: 29.04.2009
(51) Int. Cl.: H01L 33/50, H01L 33/58, C03B 11/08, C03B 19/10, C03B 23/00, C09K 11/02, C09K 11/08

(54) **Herstellungsverfahren von Optik-Konverter-Systemen für (W)LEDs**
Manufacturing method of optics-converter systems for (W)LEDs
Procédé de fabrication des systèmes optique-convertisseur pour des (W)LEDs

(30) Priorität: 29.04.2008 DE 102008021436
(43) Veröffentlichungstag der Anmeldung: 12.01.2011
(73) Patentinhaber: Schott AG, 55122 Mainz (DE)
(72) Erfinder: RINDT, Matthias, 36486 Bruchköbel (DE); PAWLOWSKI, Edgar, 55271 Stadecken-Elsheim (DE); ZETTERER, Thomas, 84034 Landshut (DE); HETTLER, Robert, 84036 Kumshausen (DE)
(74) Vertreter: Herden, Andreas F.
(86) Internationale Anmeldenummer: PCT/EP2009/003108
(87) Internationale Veröffentlichungsnummer: WO 2009/132837

(56) Entgegenhaltungen:
- EP-A1- 1 418 628
- EP-A2- 1 605 526
- DE-A1-102005 031 523
- DE-U1-202007 014 397
- JP-A- 2007 036 200
- US-A1- 2005 269 582
- US-B1- 7 078 732

## Beschreibung

Die vorliegende Erfindung betrifft ein Verfahren zur Herstellung eines Optik-Konverter-System für LEDs, vorzugsweise für sogenannte (W)LEDs.

### Hintergrund der Erfindung

Derzeit werden Systeme mit LEDs, Konvertern und Optiken mittels sogenannter Molding-Prozesse gemeinsam in einem Gehäuse, welches auch als Package bezeichnet wird, angeordnet. In einem gängigen Verfahren wird das Package direkt aus den einzelnen Komponenten aufgebaut, die dann fest miteinander verbunden werden Im Allgemeinen werden hierzu Silikonharze verwendet. Ein solches System ist beispielsweise in dem Dokument DE 10 2005 009 066 A1 beschrieben.

Ein Nachteil eines solchen Systems ist, aufgrund seiner im Wesentlichen organischen Eigenschaften, seine geringe Temperaturbeständigkeit, die im Allgemeinen nur bis zu einem Wert von etwa 100°C reicht. Aufgrund der geringen Temperaturbeständigkeit ist ein solches System bedingt kompatibel mit Lötprozessen, deren Durchführung eine hohe Wärmeentwicklung bedingen oder erfordern. Insbesondere können die im Stand der Technik verwendeten Materialien nicht weiter eingesetzt werden, wenn die derzeit in einem LED-Chip verwendete sogenannte Junction-Temperatur von derzeit maximal 100 bis 150°C auf 200°C ansteigt.

Zudem ist ein solches System nicht UV-beständig. Ferner ist ein solches Package auch nicht hermetisch und somit anfällig gegenüber Umwelteinflüssen, wie Feuchtigkeit. Die steigende Komplexität der Halbleiterbauelemente und verschiedene Applikationen verlangen jedoch ein hermetisches Package der Bauelemente. Beispiele dafür sind eine LD und ein Photodetektor oder ein LED mit Farbmonitor.

Ein weiterer Nachteil der bekannten Systeme liegt darin begründet, dass sie nicht alterungsbeständig sind. Insbesondere führen sogenannte Ausgasungseffekte der Kunststoffe zu einer Alterung des Halbleiterchips. Die vorzugsweise niedrige Wellenlänge des ausgesandten Lichtes, führt bei den derzeit verwendeten Materialien zu einer Degradation der optischen Eigenschaften und der Haftungsmechanismen. Nachteilig ist darüber hinaus auch eine geringe Wärmeleitfähigkeit der verwendeten Kunststoffe, welche insbesondere in einem Bereich von < 1 W/mK liegt.

Die einzelnen Bauteile werden hierbei im Allgemeinen fest miteinander verbunden in einem Package bereitgestellt. Eine flexible Anpassung oder Abstimmung, insbesondere der Brechungsindices der einzelnen Bauteile zueinander und an die Wellenlänge des Lichts, ist auch nur schwer oder sogar überhaupt nicht möglich. Ein anderer Nachteil ist der erhöhte Aufwand bei der Fertigung, da die einzelnen Komponenten zusammengebaut werden müssen.

Das Dokument EP 1 605 526 A2 zeigt ein anorganisches Konverterelement, welches in einem Verfahren gemäß dem Oberbegriff des Anspruchs 1 mit einer Linse verbunden wird.

Aus der Druckschrift US 2005/0269582 A1 ist ein Verfahren zur Herstellung eines Keramikplättchens durch Sintern bekannt, wobei das Keramikplättchen Leuchtstoff enthält.

### Allgemeine Beschreibung der Erfindung

Vor diesem Hintergrund hat sich die vorliegende Erfindung daher zur Aufgabe gestellt, ein Verfahren zur Herstellung eines Optik-Konverter-Systems oder eines Konverterbausteins für strahlungsemittierende Bauelemente bereitzustellen, welches die vorstehend beschriebenen Nachteile des Standes der Technik zumindest vermindert.

Insbesondere soll die vorliegende Erfindung auch zukünftigen technologischen Trends gerecht werden und insbesondere auch massenfertigungstauglich sein.

Gelöst werden diese Aufgaben durch das Verfahren gemäß Anspruch 1, der die vorliegende Erfindung definiert. Vorteilhafte Ausführungsformen sind Gegenstand der jeweiligen Unteransprüche.

Im Rahmen der Erfindung wird eine Vielzahl von Konverterbausteinen für die von zumindest einem opto-elektronischen Funktionselement emittierte und/oder zu empfangende Strahlung zum Aufsetzen auf das opto-elektronische Funktionselement hergestellt, vorzugsweise von einer LED, umfassend
- eine Vielzahl von anorganischen Konvertern zur Konversion der emittierten und/oder zu empfangenden Strahlung,
- eine Vielzahl von optischen Bauelementen, vorzugsweise umfassend ein anorganisches Material, insbesondere Glas, welches dem Konverter in Emissionsrichtung des opto-elektronischen Funktionselement nachgeordnet und/oder vorgelagert ist, wobei die Konverter und die optischen Bauelemente jeweils verbunden sind oder zumindest abschnittsweise aneinanderliegen und verbunden sind. Die Konverter und die optischen Bauelemente sind jeweils stoffschlüssig miteinander verbunden.

Es sei an dieser Stelle ergänzend klargestellt, dass die für ein strahlungsemittierendes opto-elektronisches Bauteil festgelegte Richtung, hier der Emissionsrichtung, auch für ein rein strahlungsempfangendes opto-elektronisches Bauteil gilt.

Die Erfindung betrifft ein Verfahren zur Herstellung einer Vielzahl von Konverterbausteinen gemäß Anspruch 1.

Der Konverter und/oder das optische Bauelement wird bzw. werden soweit erwärmt, dass der Konverter und/oder das optische Bauelement zumindest abschnittsweise erweichen.

Es wird eine Vielzahl der erfindungsgemäßen Konverterbausteine in einem Array oder einer Zeile bereitgestellt und/oder hergestellt.

Der Konverterbaustein wird durch zumindest zwei Bauelemente gebildet. Diese beiden Bauelemente sind das optische Bauelement und der Konverter als Konverterbauelement. Der Konverterbaustein ist ein mehrkomponentiges System. Die einzelnen Bauelemente oder Komponenten sind konstruktiv zu einer funktionsfähigen Einheit verbunden und bilden den Konverterbaustein. Die Bauelemente sind in ihren Funktionen aufeinander abgestimmt. Der Konverterbaustein als solches ist ein separates Bauteil. Unter einem Konverterbaustein wird kein optisches Bauteil, wie zum Beispiel eine Linse, verstanden, in welchem abschnittsweise Leuchtstoffe zur Konversion eingebettet sind. Der Konverterbaustein ist ein Modul für ein modular aufgebautes opto-elektronisches Bauteil. Daher wird der Konverterbaustein auch als Konvertermodul oder als Optik-Konverter-System bezeichnet werden. Die Gesamthöhe des Konverterbaustein liegt in einem Bereich von etwa 0,4 mm bis 10 mm. Er besitzt zudem einen mittleren Durchmesser von etwa 1 mm bis 20 mm. In einer Ausführungsform ist der Konverterbaustein ein anorganischer Konverterbaustein oder im Wesentlichen anorganischer Konverterbaustein.

In einer Ausführungsform ist der Konverterbaustein derart ausgebildet, dass er über einen Durchgangsbereich für die von dem opto-elektronischen Funktionselement emittierte und/oder zu empfangende Strahlung positioniert und/oder befestigt werden kann. In einer Verwendung ist der Konverterbaustein eine Art Deckel, Abdeckung oder Abschluss für ein Gehäuse, welches auch als Package bezeichnet wird.

Der Konverterbaustein ist mit dem Gehäuse verbindbar. Der Konverterbaustein kann hierbei direkt auf das Gehäuse oder das opto-elektronische Funktionselement aufgesetzt werden. Durch seinen modularen Charakter kann der Konverterbaustein aber auch über einen Adapter auf das Gehäuse oder das opto-elektronische Funktionselement aufgesetzt werden. Vorzugsweise ist in dem Package zumindest ein opto-elektronisches Funktionselement angeordnet. Das Package kann ein GTMS-Package ("Glass To Metal Seal"), Si-Package, ein Plastik-Package und/oder ein Keramik-Package sein. Vorzugsweise ist das Package ein Package, welches in der Patentanmeldung mit dem Namen *"Gehäuse für LEDs mit hoher Leistung"* beschrieben ist. Die genannte Patentanmeldung wurde am gleichen Tag wie die vorliegende Patentanmeldung eingereicht und besitzt das interne Aktenzeichen 08SGL0060DEP bzw. P3063. Der Umfang dieser Patentanmeldung wird vollumfänglich in die vorliegende Patentanmeldung inkorporiert.

Das opto-elektronische Funktionselement ist ein strahlungsemittierendes und/oder strahlungsempfangendes Bauteil. Vorzugsweise ist das Funktionselement als Chip ausgebildet. Das Funktionselement ist wenigstens ein Bauteil ausgewählt aus der Gruppe von LED, Photodiode und Laserdiode. Eine erste bevorzugte LED besitzt eine Emission in einem Bereich von etwa 370 nm bis etwa 410 nm. Eine zweite bevorzugte LED besitzt eine Emission in einem Bereich von etwa 440 nm bis etwa 480 nm Die Verwendung eines durch das erfindungsgemäße Verfahren hergestellten Konverterbausteins ist insbesondere auch für LEDs mit einer hohen Leistung, vorzugsweise mit einer Leistung von größer als etwa 5 W geeignet, da bei diesen eine effiziente Wärmeableitung erforderlich ist und neben dem Gehäuse auch der Konverterbaustein ausreichend thermisch stabil sein muss.

Der Konverterbaustein ist geeignet zum Aufsetzen auf das opto-elektronische Funktionselement und/oder auf ein Gehäuse. Der Konverter oder der Konverterbaustein kann zum einen direkt auf der LED oder dem opto-elektronischem Bauteil plaziert werden. Der Konverter steht in Kontakt mit der LED. Als Alternative kann der Konverter oder der Konverterbaustein beabstandet zur LED plaziert werden.

Der Konverter konvertiert zumindest einen Teil einer Primärstrahlung in eine Sekundärstrahlung, welche eine von der Primärstrahlung unterschiedliche Wellenlänge aufweist. Zum einen kann die Primärstrahlung von dem opto-elektronischen Funktionselement emittiert werden. Zum anderen kann die Sekundärstrahlung von dem opto-elektronischen Funktionselement empfangen werden. Maßgeblich ist hierbei zunächst das Zusammenwirken von opto-elektronischem Funktionselement und Konverter. Insbesondere ist das Zusammenwirken der Primärstrahlung mit der von dem Konverter emittierten Sekundärstrahlung maßgeblich.

Im Fall eines strahlungsemittierenden opto-elektronischen Funktionselements, wie einer LED, ergibt sich durch ein Zusammenwirken des opto-elektronischen Funktionselements und des Konverters in einer bevorzugten Ausführungsform eine sogenannte weiße LED. Von einem Empfänger wird das ausgehende Licht als weißes Licht wahrgenommen. Es wird eine sogenannte (W)LED gebildet. Hierbei wird das weiße Licht aus einer additiven Farbmischung gebildet.

Erfindungsgemäß ist der Konverter ein anorganischer Konverter oder im Wesentlichen anorganischer Konverter. Ein anorganischer oder ein im Wesentlichen anorganischer Konverter ist ein Konverter, dessen thermischen und/oder konvertierenden Eigenschaften durch seine anorganischen Bestandteile nachhaltig bestimmt wird. Insbesondere wird das Material für die Matrix, in welche die Leuchtstoffe eingebettet sind, durch wenigstens ein anorganisches Material bereitgestellt. Er besitzt eine Temperaturstabiliät von wenigstens bis zu etwa 150°C, bevorzugt von bis zu etwa 250°C, besonders bevorzugt von bis zu etwa 500°C. Der Einsatzbereich liegt besonders bevorzugt in einem Bereich von etwa -80 °C von bis zu etwa 500°C. Die Veränderung des Farbortes in Abhängigkeit von der Temperatur ist im Vergleich zu den bekannten organischen Materialien reduziert. Zudem besitzt er im Vergleich zu den üblichen organischen Konvertermaterialien eine deutlich größere Wärmeleitfähigkeit von größer als etwa 1 W/mK. Der Konverter besitzt eine Brechungsindex in einem Bereich von etwa 1,5 bis 2,0. Der Konverter besitzt ein T_{g} (Glasübergangstemperatur) von größer als etwa 500°C. Der Konverter besitzt die Eigenschaft, eine Primärstrahlung oder zumindest ein Teil davon in eine Sekundärstrahlung wenigstens einer größeren Wellenlänge zu konvertieren. Der Konverter besitzt seine konvertierenden Eigenschaften bedingt durch eine Einbettung oder Dotierung entsprechender lichtemittierender Materialien ,Leuchtstoffe oder Kristalle (z.B. Ce:YAG) und/oder bedingt durch seinen strukturellen Aufbau oder Kristallaufbau. Der Konverter besteht aus zumindest einem Material oder umfasst zumindest ein Material ausgewählt aus der Gruppe aus Opto-Keramik, Glaskeramik, keramisiertes Glas und PiG (Phosphor in Glas). Vorzugsweise ist das Material für den Konverter wenigstens ein Material, welches in der Patentanmeldung mit dem Namen "Konversionsmaterial insbesondere für eine, eine Halbleiterlichtquelle umfassende weiße oder farbige Lichtquelle, Verfahren zu dessen Herstellung sowie dieses Konversionsmaterial umfassende Lichtquelle " beschrieben ist. Die genannte Patentanmeldung wurde am gleichen Tag wie die vorliegende Patentanmeldung eingereicht und besitzt das interne Aktenzeichen 08SGL0097DEP bzw. P3179. Der Umfang der Patentanmeldung wird vollumfänglich in die vorliegende Patentanmeldung inkorporiert.

Der Konverter ist im Allgemeinen eine Art Platte oder Konverterplatte. Der Konverter ist bei im Einsatz üblichen Temperaturen im Wesentlichen nicht plastisch verformbar.. In einer Ausgestaltung ist der Konverter mehrstufig oder mehrlagig ausgeführt. Er ist hierbei zumindest 2-stufig oder 2-lagig ausgeführt. Die einzelnen Lagen können unterschiedliche Konversionseigenschaften, insbesondere hinsichtlich der umzusetzenden Primärstrahlung und/oder der generierten Sekundärstrahlung, haben. Es können aber auch Streu- und/oder Diffusorzentren in den einzelnen Lagen vorhanden sein.

Der Konverter kann zum Beispiel auch wenigstens eine Beschichtung auf der Außenseite, wenigstens eine Strukturierung oder Struktur in der Oberfläche und/oder in seinem Bulk oder Volumen eingebettete Teilchen aufweisen. Eine Beschichtung kann zum Beispiel eine, insbesondere wellenlängenselektive, Antireflexschicht sein, welche vorzugsweise auf der Unterseite des Konverters angeordnet ist. Ferner kann auch eine Beschichtung des Konverters, vorzugsweise auf seiner Oberseite, mit optischen Filtern z.B. Antireflex-Beschichtungen oder Bandpassfiltern erfolgen, um z. B. Farbspektren zu homogenisieren. Eine Strukturierung kann zum Beispiel eine durch ein Aufrauhen behandelte Oberfläche des Konverters, vorzugsweise seiner Unterseite und/oder seiner Oberseite, sein. Ein gezieltes Aufrauhen der Konverteroberfläche kann erfolgen beispielsweise durch Ätzen und/oder Sandstrahlen, um die Auskopplungseffizienz zu erhöhen. Streu- und/oder Diffusorzentren sind Beispiele für eingebettete Teilchen. Daher weist der Konverter oder zumindest eine Lage des Konverters in einer Ausführungsform insbesondere zumindest abschnittsweise oder vollständig, vorzugsweise in der Oberseite und/oder in der Unterseite, eine Beschichtung, eine Strukturierung und/oder eingebettete Teilchen auf. Die Oberfläche des Konverters kann hierzu auch gebeizt, geglättet, aufgerauht, poliert und/oder geschliffen sein.

Die Höhe oder Dicke des Konverters liegt im Allgemeinen in einem Bereich von etwa 0,05 mm bis 1 mm. In einer erfindungsgemäßen Variante ist der Konverter planar oder im Wesentlichen planar. In einer weiteren Variante ist der Konverter nicht planar. Der Konverter 1 ist gekrümmt oder abschnittsweise gekrümmt ausgebildet. Auch das optische Bauelement ist in einer Ausgestaltung gekrümmt oder abschnittsweise gekrümmt. Die Krümmung des optischen Bauelements ist vorzugsweise an die Krümmung des Konverters angepasst.

Ferner sind auch die Brechungsindices des Konverters und des optischen Bauelements aneinander angepasst. Der Unterschied zwischen dem Brechungsindex des Konverters und des optischen Bauelement beträgt hierbei weniger als 0,4 , vorzugsweise weniger als 0,1.

Denn maßgeblich ist auch das Zusammenwirken von opto-elektronischem Funktionselement, Konverter und optischem Bauelement. Der Konverter und das optische Bauelement sind mittelbar oder unmittelbar miteinander verbunden. Vorzugsweise sind der Konverter und das optische Bauelement jedoch unmittelbar miteinander verbunden. Sie sind insbesondere stoffschlüssig miteinander verbunden. Unter dem Aneinanderliegen von Konverter und optischen Bauelement wird auch ein Kontakt über einen Kleber, Lot oder ein Bindemittel verstanden. Das optische Bauelement ist im Wesentlichen transparent für die Primärstrahlung und/oder die Sekundärstrahlung. In einer Ausführungsform ist das optische Bauelement im Wesentlichen transparent für die Strahlung von der LED und für die von dem Konverter emittierte Strahlung.

Ein optisches Bauelement ist ein Bauelement, mit welchem der Strahlengang der Strahlung, welche von dem Konverter und/oder von dem opto-elektronischen Funktionselement emittiert und/oder empfangen wird, gezielt beeinflusst, insbesondere geführt und/oder abgelenkt wird. Eine Beeinflussung ist zum Beispiel eine durch Brechung, Reflexion, Streuung und/oder Diffraktion bedingte Abweichung von der geradlinigen Ausbreitung des Lichts.

Ein optisches Bauelement ist zum Beispiel ausgebildet als ein optisches System mit abbildenden Eigenschaften, wie eine konkave und/oder konvexe Linse, ein Lichtfilter, ein Diffusor, ein Lichtleiter, ein Prisma, ein sogenanntes DOE ("Diffractive Optical Element") und/oder ein Konzentrator. Ist das optische Bauelement als Konzentrator ausgebildet, so ist es in einer Variante der Erfindung auf der Oberseite des Konverters angeordnet oder dem Konverter nachgeordnet.

Hierbei ist dann in einer weiteren Ausgestaltung noch ein weiteres optisches Bauelement, wie eine Linse, auf dem Konzentrator angeordnet oder dem Konzentrator nachgeordnet. Der Konzentrator besteht aus oder umfasst Glas und/oder Plastik.

Die Aufzählung der vorstehend angeführten Beispiele eines optischen Bauelements ist nicht abschließend. Das optische Bauelement wird nachfolgend auch als Optik bezeichnet. Unter einem optischen Bauelement wird insbesondere keine "einfache", insbesondere abschließende, Abdeckung oder Schale, wie eine Platte oder Glasplatte verstanden. Jedoch kann ein optischen Bauelement auch ein "einfacher" Körper, wie ein transparente Platte oder Glasplatte, sein, wenn er durch eine entsprechende Ausbildung oder Behandlung, zum Beispiel seiner Oberfläche und/oder des Volumens, die gewünschten Licht beeinflussenden Eigenschaften aufweist. Zum Beispiel kann der Körper wenigstens eine Beschichtung auf der Außenseite, wenigstens eine Strukturierung oder Struktur in der Oberfläche und/oder in dem Material eingebettete Teilchen aufweisen. Eine Beschichtung kann zum Beispiel eine, insbesondere wellenlängenselektive, Antireflexschicht sein. Eine Strukturierung kann zum Beispiel eine durch ein Aufrauhen behandelte Oberfläche des optischen Bauelements sein. Streu- und/oder Diffusorzentren sind Beispiele für eingebettete Teilchen. Daher weist das optische Bauelement in einer Ausführungsform insbesondere zumindest abschnittsweise oder vollständig, vorzugsweise in der Oberseite und/oder in der Unterseite, eine Beschichtung, eine Strukturierung und/oder eingebettete Teilchen auf. Die Oberfläche des optischen Bauelement kann hierzu gebeizt, geglättet, aufgerauht, poliert und/oder geschliffen sein. Jedoch kann ein optisches Bauelement auch ein "einfacher" Körper, wie ein transparente Platte oder Glasplatte, sein, wenn dieser eine Art Übergang oder Zuführung zu dem eigentlichen Licht beeinflussenden optischen Bauteil darstellt. Das optische Bauteil wäre dann mittelbar mit dem Konverter verbunden. Dieser Körper könnte auch mittelbar mit dem Konverter verbunden sein.

Das optische Bauelement besitzt ein T_{g} (Glasübergangstemperatur) von kleiner als etwa 800°C. Das Material oder das Glas des optischen Bauelements weist ein T_{g} auf, welche in etwa 50 bis 300 °C unter dem T_{g} des Konverters liegt. In einer Ausführungsform ist das optische Bauelement ein anorganisches optisches Bauelement oder im Wesentlichen anorganisches optisches Bauelement oder ein optisches Bauelement aus Glas oder umfassend Glas. In einer Ausführungsform ist das Glas ein Milchglas. Insbesondere in Abhängigkeit von dem Verfahren zur Herstellung des Konverterbausteins ist das Glas des optischen Bauelements wenigstens ein Material, vorzugsweise ein Glas, welches eine T_{g} von kleiner als etwa 800°C besitzt. Beispiele dafür sind SCHOTT 8337, P-SK 57, 8250 und P-LASF 47. Das Material des optischen Bauelements kann auch ein anorganisches, einkristallinesoder polykristallines Material sein, wie z.B. Saphir-. Das Material des optischen Bauelements besitzt eine Brechungsindex in einem Bereich von etwa 1,4 bis 2,0. Es besitzt zudem eine Temperaturstabilität von größer als etwa 400°C.

In einer Ausgestaltung wird das optische Bauelement durch eine Vielzahl von kleineren optischen Bauelementen gebildet. Diese sind hierbei vorzugsweise in einer Ebene auf dem Konverter angeordnet.

In einer Weiterbildung der vorliegenden Erfindung weist der erfindungsgemäße Konverterbaustein ein weiteres optisches Bauelement auf, welches auf der gegenüberliegenden Seite des Konverters angeordnet ist. Das weitere optische Bauelement ist dem Konverter in Emissionsrichtung des opto-elektronischen Funktionselement vorgelagert bzw. nachgeordnet. Zum Beispiel kann das aus einer LED ausfallende Licht mittels einer Konvexlinse auf den Konverter gebündelt werden. Das weitere optische Bauelement kann hierbei die gleichen Eigenschaften besitzen oder genauso bereitgestellt werden wie das vorstehend beschriebene erste optische Bauelement. Zur Vermeidung von Wiederholungen sei daher auf die entsprechenden Beschreibungsteile verwiesen. In einer Ausgestaltung ist ein Konzentrator, vorzugsweise als ein weiteres optisches Bauelement, auf der Unterseite des Konverters angeordnet oder dem Konverter vorgelagert, insbesondere zur Bündelung des aus einer LED ausfallenden Lichts.

In einer erfindungsgemäßen Ausführungsform weist der Konverterbaustein zumindest einen Ring, vorzugsweise einen Metallring, auf, welcher sich zumindest abschnittsweise oder vollständig über den Umfang des Konverterbausteins erstreckt. Der Ring kann zum einen eine Begrenzung für das definierte Einschmelzen oder Erschmelzen des optischen Bauelements darstellen. Daher erfolgt das Bereitstellen des Rings im Allgemeinen vor dem Bereitstellen des optischen Bauelements oder vor einem Einschmelzen eines Glaspostens zur Bildung des optischen Bauelements. Zum anderen ist der Ring eine Art Träger für den Konverterbaustein. Weiterhin kann das Verbinden des Gehäuses mit dem Konverterbaustein mittels des Rings erfolgen. Der Ring liegt im Allgemeinen sowohl an dem Konverter als auch an dem optischen Bauelement an. Der Ring kann auch als Kühlkörper für den Konverterbaustein dienen. Daher weist dieser bevorzugt Materialien auf, welche eine entsprechende Leitfähigkeit für Wärme besitzen, wie ein Metall oder eine Metall-Legierung. Vorzugsweise besitzt der Ring eine Wärmeleitfähigkeit von zumindest etwa 10 W/mK,. In Abhängigkeit von dem Gehäuse oder der Verbindung des Konverterbausteins mit dem Gehäuse wird der Ring verwendet oder nicht.

In einer weiteren Ausgestaltung der Erfindung weist der Ring, zumindest abschnittsweise oder vollständig, eine vorzugsweise metallische Beschichtung oder Verkleidung auf. Die Beschichtung ist vorzugsweise eine Metallisierung. Die metallische Beschichtung oder Verkleidung ist insbesondere an dem freiliegenden Teil der Außenseite angeordnet. Im Detail ist der Kontaktbereich zu oder die Anlagefläche an einem Gehäuse beschichtet oder verkleidet. Die Beschichtung oder die Verkleidung ist ein Korrosionsschutz für den Ring und/oder ein Bindemittel, wie ein Lötwerkstoff, zur Verbindung mit dem Gehäuse.

Eine weitere Ausführung des Konverterbausteins besitzt zumindest ein Mittel zur Wärmeabfuhr. Das Mittel wird zum Beispiel bereitgestellt durch zumindest eine Metallschicht und/oder eine Diamantschicht (z.B. "Synthetic Diamond"). Ein Metall mit hoher Wärmeleitfähigkeit ist zum Beispiel Kupfer. Das Mittel wird als eine Art Draht oder Leitung, vorzugsweise ausgebildet als eine Art Netz oder Gitter, bereitgestellt. Es kann sich hierbei um eine gedruckte Schaltung handeln, welche auch als thermische Bus Bars bezeichnet werden. Das Mittel wird auf der Unterseite des Konverters, auf der Oberseite des Konverters und/oder in den Konverter integriert. Bei sogenannten Arrays verläuft das Mittel im wesentlichen zwischen den optischen Bauelementen. In einer Ausführungsform verläuft das Mittel um das optische Bauelement herum

In einer Weiterbildung der Erfindung ist das optische Bauelement zumindest abschnittsweise bearbeitet oder behandelt. Vorzugsweise ist die Oberseite und/oder die Unterseite des optischen Bauelements bearbeitet. Das Bearbeiten kann ein Struktuieren und/oder ein Beschichten sein oder umfassen. Um zum Beispiel eine verbesserte Ausleuchtung zu erzielen kann das optische Bauelement aufgeraut werden. Es wird eine erhöhte diffuse Reflexion erzielt. D.h. das aus einer bestimmten Richtung einfallende Licht wird in viele verschiedene Richtungen gestreut. Das optische Bauelement kann aber auch, insbesondere wellenlängenselektiv, reflektierend ausgebildet werden.

Das Bereitstellen oder das Positionieren des Konverters, des Konvertermaterials, des Glaspostens, des optischen Bauelements, des Materials für das optische Bauelement und/oder des Rings erfolgt bzw. erfolgen in einer Ausführungsform über einen sogenannten "Pick-and-Place-Prozess" .

In einer Ausführungsform wird eine Form zur Aufnahme zumindest eines Konverters und/oder zumindest eines optischen Bauelements oder zumindest eines Glaspostens oder zumindest einer Vorform bereitgestellt. Das Bereitstellen der jeweiligen vorstehend genannten Komponente erfolgt über ein Positionieren auf oder in der Form. Unter einem Positionieren auf der Form wird verstanden, dass die Komponenten auf der Oberfläche der Form plaziert wird. Ein Abschnitt oder zumindest ein Abschnitt seiner Unterseite steht in Kontakt mit der Oberfläche der Form.

Gemäß einem Aspekt der Erfindung wird das optische Bauelement in einem ersten Schritt bereitgestellt. Das optische Bauelement wird hierbei über ein Einschmelzen bereitgestellt. Das Bereitstellen des optischen Bauelement umfasst das Bereitstellen einer Form, das Positionieren eines Glaspostens auf bzw. in der Form und das Erwärmen des Glaspostens insoweit, dass das Material eine Viskosität erreicht, bei der das Material fließfähig wird und sich das optische Bauelement ausbildet. Vorzugsweise sinkt das Material hierbei in die Form ein. Das optische Bauelement kann auch hier als ein Glasposten oder eine Vorform bereitgestellt werden, aus welchem bzw. welcher dann das optische Bauelement über ein Aufschmelzen ("Reflow") gebildet wird. Um Wiederholungen zu vermeiden, sei hierzu auf die nachfolgende entsprechende Beschreibung verwiesen.

Nachfolgend erfolgt eine Bearbeitung, insbesondere ein Oberflächenbearbeitung, des optischen Bauelements. Durch die Bearbeitung werden die Eigenschaften des optischen Bauelements verbessert und/oder eingestellt. Das optische Bauelement wird nach der Bearbeitung mit dem bereitgestellten Konverter verbunden.

Eine erste Möglichkeit der Bearbeitung ist das Beizen des optischen Bauelements, vorzugsweise mittels HF und/oder HCl. Das Beizen hat sich als vorteilhaft erwiesen für den Fall, wenn das optische Bauelement auch die Eigenschaften eines Diffusors besitzen soll. Eine weitere Behandlung des optischen Bauelements zur Erzeugung dieser Funktion ist nicht mehr erforderlich.

Sofern jedoch eine besonders glatte Oberfläche erzielt werden soll, erfolgt, insbesondere nachfolgend, ein Glätten oder ein Polieren, vorzugsweise eine Feuerpolitur, der Oberfläche des optischen Bauelements.

Eine weitere Möglichkeit stellt das Schleifen des optischen Bauelements dar. Durch das Schleifen kann die Oberfläche des optischen Bauelements geglättet, aufgerauht und insbesondere auch eine Struktur erzeugt werden. Es kann eine Rauigkeit der Oberfläche erzeugt werden, so dass eine Eigenschaft eines Diffusors gebildet wird. Zum anderen kann auch die Seite des optischen Bauelements, an welcher der Konverter angeordnet werden soll, geschliffen, vorzugsweise plangeschliffen, und/oder poliert werden.

Der Konverter oder das Material des Konverters wird bereitgestellt durch ein Aufbringen auf das optische Bauelement, vorzugsweise auf dessen Unterseite. Der Konverter wird bereitgestellt durch Aufdrucken, wie Siebdrucken und/oder mittels einer Schablone, durch Dispensen, durch Aufsintern, vorzugsweise eines Presslings oder Vorformlings, und/oder durch Laminieren einer Folie. Eine Folie kann zum Beispiel durch in die Form eines Bandes gegossenen Schlickers bereitgestellt werden.

In einer ungesinterten Ausführungsform des optischen Bauelements, wie für ungesintertes PiG, wird der Konverter durch Aufdrucken, Auflaminieren, Aufsintern, Aufsintern und/oder Dispensen bereitgestellt. In einer vorgesinterten Ausführungsform, wie für PiG und/oder keramisiertes Glas und/oder Glaskeramik, wird der Konverter als Tape und/oder als Sinterling bereitgestellt. Eine weitere Alternative stellt das Bereitstellen eines organischen Konverters dar.

Der Konverter und das optische Bauelement werden in einem nachfolgenden Schritt miteinander verbunden. Gemäß der Erfindung erfolgt das Verbinden über ein Sintern des Konverters. Das Sintern kann mit oder ohne Druck erfolgen.

Gemäß einen weiteren Aspekt der Erfindung wird in einem ersten Schritt zunächst der Konverter bereitgestellt. In einer ersten Ausführungsform wird der Konverter als eine Lage oder Art Platte bereitgestellt. Der Konverter ist hier ein Formkörper. Er ist somit im Wesentlichen formstabil. Der Formkörper besitzt eine eigene Standfestigkeit. Der Formkörper kann hierbei formstabil aber noch verformbar sein. Vorzugsweise wird der Konverter in einer Form positioniert.

In einer anderen Ausführungsform wird der Konverter, vorzugsweise für einen PiG-Konverter, zunächst als ein schüttfähiges Material bereitgestellt, welches in einer Form positioniert oder in eine Form eingebracht wird. Ein schüttfähiges Material ist ein Material, welches im Wesentlichen durch kleine Konverterteilchen, wie zum Beispiel als eine Art Pulver oder Kügelchen oder Körner, bereitgestellt wird.

In einem nachfolgenden Schritt wird der Konverter oder die Gestalt des Konverters durch ein Pressen des schüttfähigen Materials oder der Teilchen gebildet. Die Teilchen haften mechanisch zusammen. Es wird ein Formkörper gebildet. Es kann sogar schon aufgrund des angelegten Drucks zu einem Art Kalt-Verschweißen der Teilchen an ihren Berührungsflächen kommen. Zusätzlich zum Pressen und/oder nach dem Pressen kann der gebildete Formkörper bzw. das schüttfähige Material, welches den Konverter bildet, soweit erwärmt werden, dass diese aneinander haften. Der Konverter wird somit über einen Sinterprozess bereitgestellt oder hergestellt.

In einer Ausführungsform wird das optische Bauelement an sich bereitgestellt. Es besitzt hierbei im Wesentlichen bereits seine "finale" Gestalt. Konverter und/oder das optische Bauelement werden soweit erwärmt, dass diese aneinander haften und einen Verbund bilden. Sie werden über ein Sintern verbunden.

In einer anderen Ausführungsform wird das optische Bauelement durch ein Pressen und/oder Erwärmen eines schüttfähigen Materials, aus welchem das optische Bauelement geformt wird, gebildet. Das optische Bauelement wird somit ebenso über einen Sinterprozess hergestellt. Es ist sozusagen eine Art 2-stufiges Sintern.

In einer weiteren Ausführungsform, die eine Art 1-stufiges Sintern darstellt, wird die Form sequentiell befüllt. Das Bereitstellen des Konverters und des optischen Bauelement erfolgt hierbei derart, dass die Form zunächst mit dem Material befüllt wird, welches den Konverter bilden wird, und dann mit dem Material befüllt wird, welches das optische Bauelement bilden wird. Beide Materialien sind vorzugsweise jeweils ein schüttfähiges Material. Über ein gemeinsames Pressen und/oder Erwärmen der beiden Materialien werden zum einen der Konverter und das optische Bauelement gebildet und gleichzeitig dazu auch der Verbund aus Konverter und optischen Bauelement gebildet.

In einer weiteren Ausgestaltung der Erfindung erfolgt das Bereitstellen des optischen Bauelements derart, dass das optische Bauelement als ein Glasposten oder eine Vorform bereitgestellt wird. Der Glasposten wird auch als Glasabschnitt bezeichnet.

Ein Glasposten oder eine Vorform ist ein Formkörper, aus welchem beim Erwärmen oder Aufschmelzen das optische Bauelement gebildet oder geformt wird. Das Ausbilden des optischen Bauelements erfolgt über ein definiertes Kollabieren oder Zusammenfallen des Formkörpers bzw. des Glaspostens durch die durch seine Erwärmung bedingte verringerte Viskosität. Die Gestalt des Formkörpers kann schon an die an die Gestalt des zu bildenden optischen Bauelements angepasst sein. Der Formkörper kann auch porös sein. Er kann auch mehrteilig sein. Hierbei wird in einer Ausführungsform der Glasposten oder die Vorform auf den Konverter aufgesetzt, aufgepresst und/oder mit dem Konverter verbunden.

In einer weiteren Ausführungsform wird der Glasposten oder die Vorform über ein sogenanntes "Jetting"-Verfahren bereitgestellt. Damit ist ein Verfahren bezeichnet, bei welchem das Glas oder das Material in einem derart niedrigviskosen Zustand bereitgestellt wird, dass es sozusagen aufgespritzt oder tropfenweise appliziert werden kann. Die Viskosität liegt in einem Bereich von etwa 10² dPas bis etwa 10⁴ dPas. Zur Illustration: Das genannte "Jetting"-Verfahren ist zum Beispiel ähnlich mit der Funktionsweise eines Tintenstrahldruckers .

In einer anderen Ausführungsform wird der Glasposten oder die Vorform über ein Strukturieren oder sogenanntes Mikrostrukturieren bereitgestellt. Dazu wird in einer Variante ein Glaskörper oder Körper, vorzugsweise eine Platte, auf dem Konverter plaziert und/oder durch ein Abscheideverfahren, wie zum Beispiel PVD ("Physical Vapor Deposition"), auf dem Konverter erzeugt. In der zuerst genannten Version wird der Glaskörper oder der Körper auf den Konverter aufgesetzt, aufgepresst und/oder mit dem Konverter verbunden, zum Beispiel über ein Sintern. Optional wird oder ist der Glaskörper oder der Körper vor dem Strukturieren insoweit erwärmt, dass dieser eine Viskosität erreicht oder besitzt, bei welcher das er an dem Konverter haftet. Der Glaskörper oder Körper wird auf dem Konverter "aufgesintert". Der Glasposten oder die Vorform wird durch ein materialabtragendes Verfahren erzeugt. Das Verfahren umfaßt dabei die folgenden Schritte: 1.) Aufbringen einer Maske auf den Glaskörper oder Körper, welche die Struktur des Glaspostens oder der Vorform abbildet, 2.) Entfernen der freiliegenden Bereiche des Glaskörpers oder des Körpers mittels Lift-Off-Technik und 3.) Entfernen der Maske. Es verbleibt der Glasposten oder die Vorform auf dem Konverter. In einer weiteren Variante des Strukturierens wird zunächst eine Maske auf den Konverter aufgebracht, welche die Struktur des Glaspostens oder der Vorform abbildet. In einem nächsten Schritt wird ein Glaskörper oder ein Körper auf dem Konverter durch ein Abscheideverfahren, wie zum Beispiel PVD ("Physical Vapor Deposition"), abgeschieden. Durch einen sogenannten Lift-off wird die Maske, d.h. die Bereiche der Maske, welche den Konverter bedecken, entfernt. Es verbleibt der Glasposten oder die Vorform auf dem Konverter.

In einer weiteren Ausführungsform wird der Glasposten oder die Vorform insoweit erwärmt, dass dieser oder diese eine Viskosität erreicht oder besitzt, bei welcher das Material an dem Konverter haftet. Der Glasposten oder die Vorform wird auf dem Konverter "aufgesintert". Es bildet sich ein Verbund.

In einem nächsten Schritt wird der Glasposten oder die Vorform erwärmt und insoweit aufgeschmolzen oder niedrigviskos, dass sich das erste optische Bauelement, vorzugsweise als eine im Wesentlichen halbkugelförmige Linse, ausbildet. Ein solches Aufschmelzen wird als sogenannter "Reflow" bezeichnet. Damit sich das optische Bauelement definiert ausbilden kann, wird das Material auf eine Viskosität erwärmt, die in einem Bereich von etwa 10³ dPas bis etwa 10⁸ dPas liegt. Das Material oder das Glas des optischen Bauelements weist hierzu eine T_{g} auf, welche in etwa 50 bis 300 °C unter dem T_{g} des Konverters liegt.

Um den Glasposten oder die Vorform definiert aufschmelzen zu können, werden auf, über und/oder in der Seite des Konverters, auf der das optische Bauelement aufgebracht werden soll, Begrenzungen oder zumindest eine Begrenzung bereitgestellt oder angeordnet. Die Begrenzung ist eine Art Grenze oder Formhilfe für das Kollabieren oder Zerfließen des Glaspostens oder der Vorform, so dass sich das optische Bauelement aufgrund der Oberflächenspannung definiert ausbilden kann. Vorzugsweise bildet sich im Wesentlichen eine Konvexlinse als optisches Bauelement aus. Die Begrenzung erstreckt sich zumindest abschnittsweise oder im Wesentlichen vollständig über den Umfang des Glaspostens oder der Vorform. Sie definiert eine Grenze für die Größe und die Gestalt des sich ausbildenden optischen Bauelements. Die Gestalt und die Größe der Begrenzung bilden sich zumindest in einem Sockelbereich des optischen Bauelements ab.

Die Begrenzung ist in einer Ausführungsform eine Diskontinuität in der Oberfläche oder der Seite des Konverters, auf der das optische Bauelement aufgebracht oder ausgebildet werden soll. Es ist zum Beispiel eine Art Unterbrechung in einer planen Ebene. Vorzugsweise können dadurch auf einem Konverter auch eine Vielzahl an kleineren optischen Bauelementen erzeugt werden.

Die Begrenzung wird durch ein Strukturieren der Seite, des Konverters, auf der das optische Bauelement aufgebracht oder ausgebildet werden soll, erzeugt.

Hierbei werden in einer Ausführungsform Erhebungen oder Stege auf der entsprechenden Seite des Konverters erzeugt. In einer Ausgestaltung wird die Begrenzung über ein additives oder materialauftragendes Verfahren erzeugt. Eine Ausgestaltung zum Erzeugen der Begrenzung ist das Aufbringen einer separaten Lage. Das Material zum Ausbilden der separate Lage ist wenigstens ein Material ausgewählt aus der Gruppe von Metall, Glas und Glaskeramik. Die Begrenzung wird zum Beispiel über einen Beschichtungsprozess, wie Aufdampfen, und/oder Bonden, wie Aufkleben und/oder Sintern und/oder Siebdruck, aufgebracht.

In einer weiteren Ausführungsform wird die Begrenzung über ein materialabtragendes Verfahren oder eine entsprechende ausgestaltetes Herstellungsverfahren des Konverters erzeugt. Hierbei werden Aussparungen, wie Schlitze und/oder Gräben, auf der entsprechenden Seite des Konverters erzeugt oder eingebracht. Diese werden auch als sogenannte "V-Grooves" bezeichnet. Die Begrenzungen werden zum Beispiel über Sandstrahlen, Ätzen, wie RIE ("Reactive Ion Etching"), Ultraschallschwingläppen, Sägen und/oder Laserablation eingebracht.

In einer anderen Ausführungsform wird eine Begrenzung über das Positionieren einer Art Schablone bereitgestellt, welche vorzugsweise knapp über oder auf der Oberseite des Konverters positioniert wird. Vorzugsweise ist die Schablone nach dem Aufschmelzen wieder entfernbar. Die Schablone besteht, vorzugsweise zumindest, aus einem Material, welches an dem viskosen Glasposten oder der viskosen Vorform nicht anhaftet. Ein Beispiel ist Graphit. Die Schablone wird nachfolgend auch als Fixierung bezeichnet.

In einer weiteren Ausführungsform wird in einem ersten Schritt zunächst wiederum das optische Bauelement bereitgestellt. Das erste optische Bauelement besitzt hierbei im Wesentlichen bereits seine "finale" Gestalt.

In einem nachfolgenden Verfahrensschritt wird nun der Konverter bereitgestellt und mit dem optischen Bauelement verbunden. Das optische Bauelement wird auf dem Konverter aufgebracht. Mögliche Verfahren zum Aufbringen des Konverters sind Siebdruck, Pyrolyse, das Aufbringen einer Folie, Flammenpyrolyse und/oder CVD Prozess ("Chemical Vapor Deposition") und/oder das Aufbringen eines sogenannten mikrostrukturierten Glases.

Gemäß einem weiteren Aspekt der vorliegenden Erfindung wird der Konverter, vorzugsweise als ein Formkörper, über einer Form positioniert. Es erfolgt in einem nächsten Schritt ein Erwärmen zumindest des Konverters insoweit, dass das Material des Konverters eine Viskosität erreicht, bei welcher der Konverter in die Form einsinkt. Damit sich der Konverter definiert ausbilden kann, wird das Material auf eine Viskosität erwärmt, die in einem Bereich von etwa 10⁵ dPas bis etwa 10⁸ dPas liegt. Um ein definiertes Durchsacken des Konverters zu ermöglichen, besitzt dieser eine mittlere Dicke oder Höhe von etwa 0,05 mm bis etwa 0,5 mm.

In der Ausführungsform, in der das optische Bauelement direkt bzw. bereits geformt bereitgestellt wird, kann dieses, vorzugsweise noch im erwärmten und somit "klebenden" Zustand des Konverters, auf den Konverter aufgesetzt und/oder aufgepresst werden, so dass sich ein Verbund aus Konverter und optischen Bauelement bildet.

In einer weiteren Ausführung umfasst das Bereitstellen des optischen Bauelements das Bereitstellen eines Glaspostens oder einer Vorform, der bzw. die zusammen mit dem Konverter auf der Form positioniert wird. Der Glasposten oder die Vorform wird auf oder unter dem Konverter angeordnet. Je nach Ausführungsform kann der Glasposten oder die Vorform vor, während und/oder nach dem Einsinken des Konverters positioniert werden.

Der Glasposten oder die Vorform und der Konverter werden insoweit erwärmt, dass diese jeweils eine Viskosität erreichen, bei welcher der Konverter und der Glasposten oder die Vorform in die Form, insbesondere gemeinsam oder nacheinander, einsacken. Der Konverter und der Glasposten oder die Vorform haften aneinander. Es bildet sich ein Verbund. Beim Einsacken oder Durchsacken wird auch zugleich das optische Bauelement aus dem Glasposten oder der Vorform gebildet.

In einer Ausführungsform wird der Glasposten oder die Vorform, vorzugsweise nach dem Einsacken des Konverters, soweit erwärmt und aufgeschmolzen, dass das Material eine Viskosität erreicht, bei der sich das optische Bauelement, vorzugsweise als eine im Wesentlichen halbkugelförmige Linse, ausbildet. Ein solches Aufschmelzen wird als sogenannter "Reflow" bezeichnet. Für weitere Details oder Verbesserungen des "Reflows" sei zur Vermeidung von Wiederholungen auf die entsprechende Beschreibung verwiesen.

Gemäß einem weiteren Aspekt der Erfindung werden der Konverter und der Glasposten oder die Vorform oder das optische Bauelement in einer Form, nacheinander oder gleichzeitig, angeordnet. Der Konverter und der Glasposten oder die Vorform oder das optische Bauelement werden durch Pressen, vorzugsweise durch sogenanntes Blankpressen, und Erwärmen miteinander verbunden. Im Fall des Glaspostens oder der Vorform bildet sich beim Pressen auch gleichzeitig das optische Bauelement aus.

In einer Ausgestaltung wird die Kontaktfläche der Form, vorzugsweise die Kontaktfläche zum optischen Bauelement, zumindest abschnittsweise strukturiert bereitgestellt. So kann beim Verbinden der beiden Bauelemente, d.h. des Konvertes und des optischen Bauelements, eine Struktur, wie eine DOE-Struktur oder eine Mikrooptik-Struktur, in den Konverter und/oder das optische Bauelement eingebracht werden. Zum Beispiel kann hierbei die Struktur einer Fresnellinse in die Oberseite des optischen Bauelements geprägt werden.

Gemäß einem weiteren Aspekt der Erfindung wird bzw. werden der Konverter und/oder das optische Bauelement an sich bereitgestellt. Hierbei ist jeweils im Wesentlichen bereits die "finale" Gestalt erreicht. Der Konverter und/oder das optische Bauelement wird bzw. werden zum Beispiel durch Pressen, vorzugsweise durch sogenanntes Blankpressen, hergestellt.

Gemäß der Erfindung erfolgt das Verbinden von Konverter und optischem Bauelement über Sintern. Dabei wird bzw. werden der Konverter und/oder das optische Bauelement soweit erwärmt, dass diese aneinander haften und einen Verbund bilden.

Gemäß der Erfindung wird nicht nur ein einzelner Konverterbaustein allein sondern werden eine Vielzahl von Konverterbaustein gemeinsam hergestellt und/oder bereitgestellt weiden. Daher liegt im Bereich der vorliegenden Erfindung auch ein Array oder eine Anordnung, welches bzw. welche eine Vielzahl der vorstehend beschriebenen Konverterbausteine umfasst. Das Array ergibt sich in einer Ausführungsform dadurch, dass die Ringe als Matrix bereitgestellt werden. Ein Ring wird, insbesondere wenn er aus einem metallischen Material gefertigt ist, durch ein sogenanntes Leiterrahmenverfahren hergestellt, wie z.B. photochemisches Ätzen, Stanzen, Laser-Schneiden und/oder Wasserstrahlschneiden. In einer Ausführungsform wird eine Platte derart strukturiert, dass eine Vielzahl an Ringen pro Platte entsteht. Der Ring ist Bestandteil einer Matrix von einzelnen Gehäusen. Eine Matrix ist eine Art Grundkörper, in welchem die Ringe eingelagert oder angeordnet sind. Die einzelnen Ringe sind mittels sogenannter Stege oder Verbindungsstege an der jeweilige Matrix befestigt.

Weiterhin wird ein opto-elektronisches Bauteil beschrieben, welches zumindest ein Gehäuse, zumindest einen Konverterbaustein, der gemäß der vorliegenden Erfindung hergestellt wurde, und wenigstens ein opto-elektronisches Funktionselement, insbesondere eine LED, welches in dem Gehäuse angeordnet ist, umfasst. In einer Ausführungsform weist das opto-elektronische Bauteil zumindest eine LED und zumindest ein Monitor-Bauelement, wie zum Beispiel eine Photodiode, und/oder zumindest ein Thermoelement auf. Diese sind an dem opto-elektronischen Bauteil, vorzugsweise in dem Gehäuse, angeordnet. Mittels des Monitor-Bauelements kann die Lichtintensität der LED überwacht und/oder geregelt werden. Mittels des Thermoelements kann die Temperatur der LED überwacht und/oder geregelt werden.

Ferner wird auch eine Beleuchtungseinrichtung beschrieben, welche wenigstens einen Konverterbaustein und/oder ein opto-elektronisches Bauteil beinhaltet. Beispiele für die Beleuchtungseinrichtung sind eine Sitzbeleuchtung; ein Leselicht; eine Arbeitsleuchte, die insbesondere in Decken oder Wänden integrierbar ist; eine Objektbeleuchtung in Möbeln und/oder Gebäuden; einen Scheinwerfer und/oder ein Rücklicht und/oder eine Innenbeleuchtung und/oder eine Instrumenten- oder Display-Beleuchtung, vorzugsweise in Kraftfahrzeugen; und/oder eine Hintergrundbeleuchtung für LCD-Displays. Die vorliegende Erfindung wird anhand der nachfolgenden Ausführungsbeispiele im Einzelnen erläutert. Hierzu wird auf die beigefügten Zeichnungen Bezug genommen. Die gleichen Bezugszeichen in den einzelnen Zeichnungen beziehen sich auf die gleichen Teile.
- Fig. 1.a bis 1.i: zeigen schematisch verschiedene Ausführungsformen des durch die vorliegende Erfindung hergestellten Optik-Konverter-Systems.
- Fig. 2.a bis 11.d: zeigen schematisch verschiedene Ausführungsformen des erfindungsgemäßen Verfahrens zur Herstellung des Optik-Konverter-Systems.
- Fig. 12.a bis 12.d: zeigen schematisch jeweils ein Optik-Konverter-System mit einem Package oder Gehäuse im zusammengebauten Zustand.

### Detaillierte Beschreibung der Erfindung

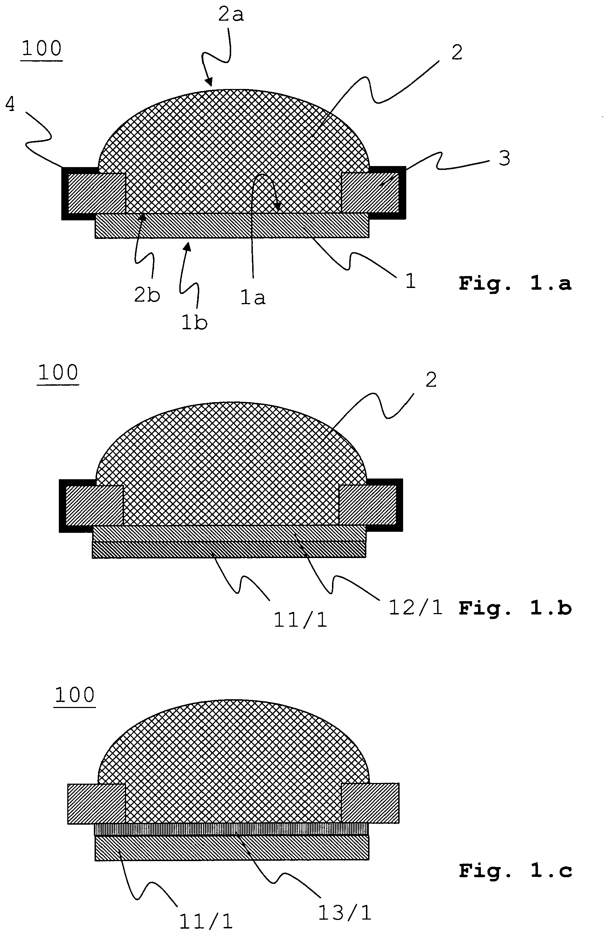

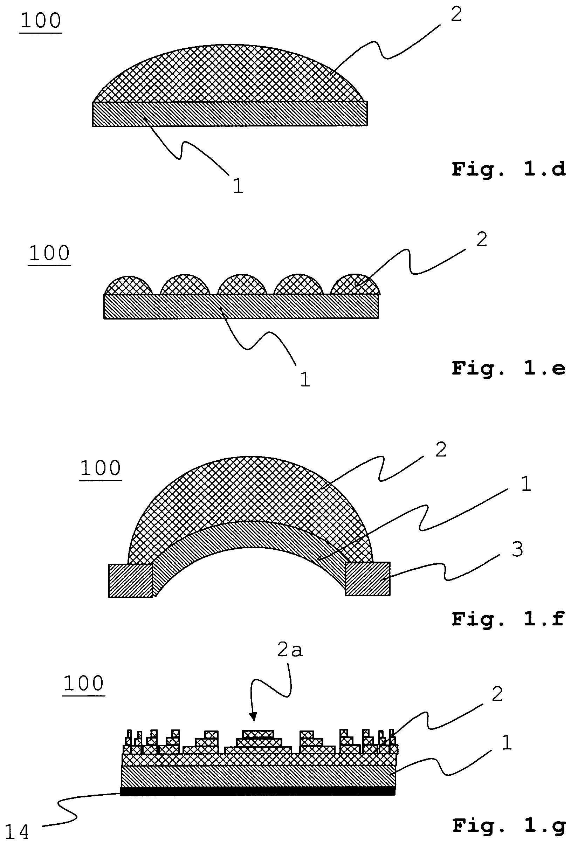

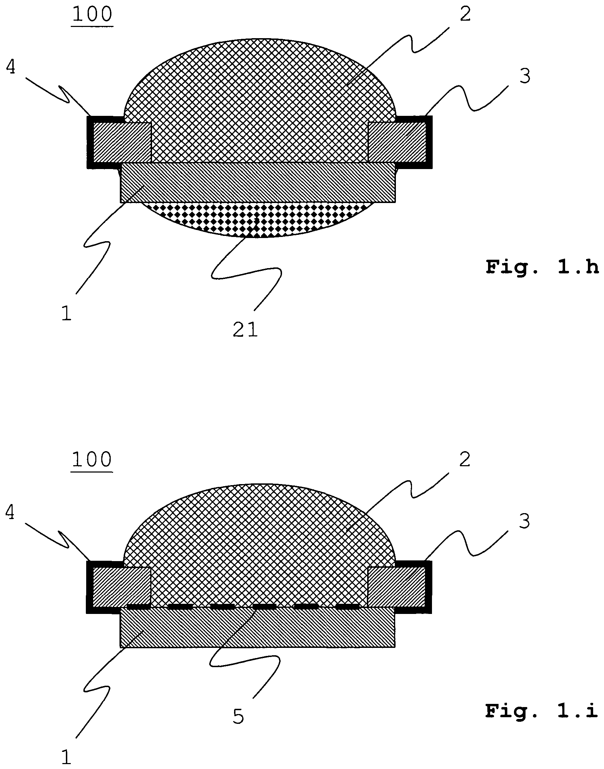

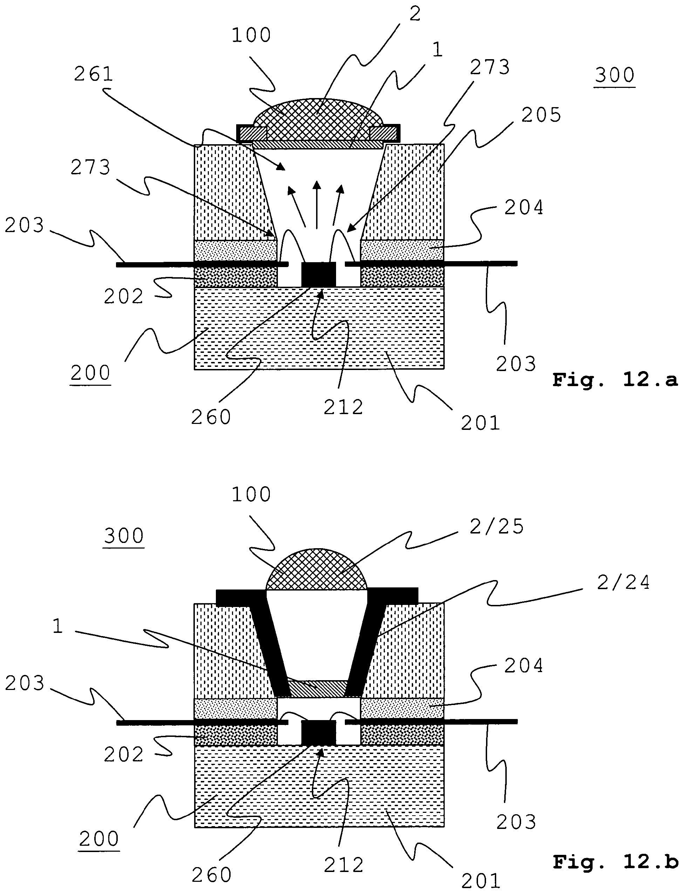

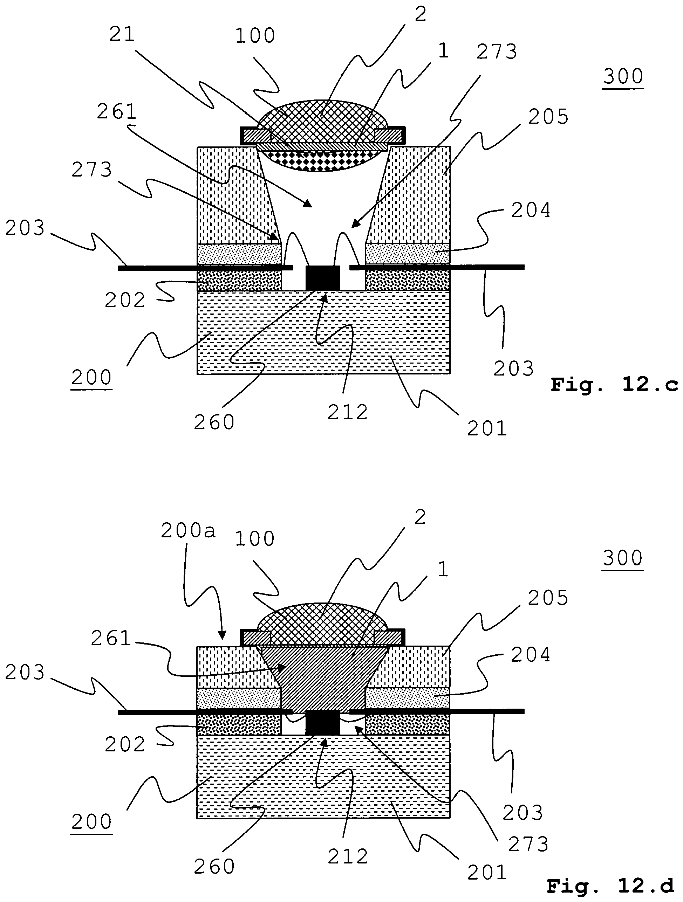

Die Figuren 1.a bis 1.i zeigen schematisch verschiedene Ausführungsformen eines Konverterbausteins 100, welcher nachfolgend als Optik-Konverter-System 100 bezeichnet wird, in einem Querschnitt. Das in Figur 1.a dargestellte System 100 besteht aus einem Konverter 1, einem optischen Bauelement 2, welches nachfolgend als Optik 2 bezeichnet wird, einem Metallring 3 und einer, vorzugsweise auf der Außenseite des Metallrings 3 aufgebrachten, Schicht 4. Die Optik 2 ist auf der Oberseite 1a des Konverters 1 angeordnet. Optik 2 und Konverter 1 sind stoffschlüssig miteinander verbunden. Die Oberseite 2a der Optik 2 oder die Optik 2 bildet zumindest abschnittsweise oder vollständig eine Konvexlinse 2. Die Konvexlinse besitzt zum Beispiel im Wesentlichen die Form einer Halbkugel. Dadurch kann das von dem Konverter 1 emittierte Licht geführt, insbesondere fokussiert, werden. Der Metallring 3 erstreckt sich vollständig über den Umfang der Optik 2. Der Ring 3 dient im Wesentlichen als Träger für das System 100 und/oder zur Wärmeabfuhr und/oder als Positionierhilfe und/oder als Befestigungsmittel, zum Beispiel für ein Gehäuse 200. Auf der Außenseite des Rings 3 ist vorliegend eine Schicht 4 oder Verkleidung 4 aufgebracht. Die Schicht 4 kann zum Beispiel als eine Beschichtung 4, insbesondere durch ein Abscheideverfahren, ausgebildet sein. Sie dient im Wesentlichen zum Korrosionsschutz und/oder zur Verbesserung der Verbindung mit einem Gehäuse 200. Hierzu sei auf die Ausführungen zu den Figuren 12.a bis 12.d verwiesen.

Die einzelnen in den Figuren 1.b bis 1.i illustrierten Ausführungsformen entsprechen teilweise der in Figur 1.a dargestellten Ausführungsform. Hinsichtlich der gleichen Komponenten sei zur Vermeidung von Wiederholungen auf die vorstehenden Erläuterungen zu Figur 1.a verwiesen. Die nachfolgenden Ausführungen beziehen sich im Wesentlichen auf die Unterschiede.

Figur 1.b zeigt eine Ausführungsform, in der der Konverter 1 als zweistufiges oder zumindest zweistufiges Konverter-System 1 ausgeführt ist. Ein mehrstufiges System kann auch als Sandwich-Aufbau bezeichnet werden. Insbesondere können hier verschiedene Konverterschichten 11 und 12, wie zum Beispiel Phosphorschichten, zu einem Konverter 1 zusammengeführt werden. Beispiele für zwei verschiedene Konverter 1 sind ein Ce YAG-Konverter 11 und ein roter Phosphor-Konverter 12.

Figur 1.c zeigt eine Ausführungsform, in der der Konverter 1 wiederum als zweistufiges oder zumindest zweistufiges System 11 und 13 ausgeführt ist. Es werden hierbei gezielt Streu- und/oder Diffusorzentren, insbesondere in einer Schicht 13, erzeugt. Ein Beispiel für ein solches zweistufiges System ist ein Ce YAG-Konverter 11 und eine vorzugsweise weiße YAG-Schicht 13.

In Abhängigkeit von der Verwendung eines Optik-Konverter-Systems 100 kann es mit oder ohne einen Ring 3 ausgestattet sein. Figur 1.d zeigt hierzu eine Ausführungsform des Optik-Konverter-Systems 100, welche nur aus dem Konverter 1 und der Optik 2 besteht.

Figur 1.e zeigt eine Ausgestaltung, bei der die Optik 2 aus einer Vielzahl von kleineren Optiken 2 aufgebaut ist. Vorliegend ist die in Figur 1.d dargestellte große Konvexlinse 2 durch eine Vielzahl von kleinen Konvexlinsen 2, welche auf der Oberseite 1a des Konverters 1 angeordnet sind, ausgetauscht oder ersetzt. Dies ermöglicht vergleichbare optische Eigenschaften der Optik 2 bei gleichzeitig reduzierter Höhe der Optik 2.

Ein Optik-Konverter-System 100 wird nicht zwangsläufig nur als planares System 100 ausgeführt. Dies ist insbesondere auch aus der in Figur 1.f illustrierten Ausgestaltung ersichtlich. Die Konverterschicht 1 oder der Konverter 1 ist nicht planar. Der Konverter 1 ist gekrümmt oder abschnittsweise gekrümmt ausgebildet. Auch die Optik 2 ist gekrümmt oder abschnittsweise gekrümmt ausgebildet.

Figur 1.g zeigt eine Ausführungsform, in der die Oberseite 2a der Optik 2 als ein sogenanntes DOE ("Diffractive Optical Element") 2 ausgebildet ist. Ein Beispiel für ein DOE 2 ist eine Fresnel-Linse. Diese ist in vereinfachter Form dargestellt. Zusätzlich ist auf der Unterseite 1b des Konverters 1 eine optionale Beschichtung 14 oder Funktionsschicht 14 aufgebracht. Eine beispielhafte Ausgestaltung einer solchen Funktionsschicht 14 ist eine Antireflex-Schicht 14, vorzugsweise zur Erhöhung der Lichtauskopplungeffizienz aus dem Optik-Konverter-System 100. Es kann hierbei zum Beispiel eine Anpassung des Brechungsindex des Konverters 1 an eine blaue LED 260 erzeugt werden.

Eine Erhöhung der Lichtauskopplungeffizienz kann, als Alternative oder als Ergänzung, durch angepasste Brechungsindices zwischen dem Konverter 1 und der Optik 2 erreicht werden. Beispielsweise kann der Konverter 1 einen Brechungsindex von 1,8 besitzen. Einen angepassten Brechungsindex der Optik 2 von 1,8 besitzt z. B. ein Glas mit niedrigem T_{G}, wie P-LASF 47.

Figur 1.h zeigt eine Ausführungsform, in der auf der Unterseite 1b des Konverters 1 eine weitere Optik 21, wie eine konvexe Linse, angeordnet oder aufgebracht ist. Durch diese weitere Optik 21 kann die aus einer LED 260 kommende Lichtstrahlung gebündelt werden. Dies führt wiederum zu einer verbesserten Auskopplungseffizienz.

Figur 1.i zeigt eine Ausführungsform, in der auf der Oberseite 1a des Konverters 1 ein Mittel 5 zur Wärmeabfuhr angeordnet oder aufgebracht ist. Das Mittel 5 zur Wärmeabfuhr ist zum Beispiel ein Gitter oder Netz aus einer Metallschicht oder Diamantschicht. Das Mittel 5 koppelt an dem Metallring 3 an oder liegt an diesem an. Dies führt zu einer verbesserten Wärmeabfuhr.

Der Konverter 1 ist vorzugsweise ein anorganischer Konverter 1 oder umfasst ein anorganisches Material. Beispiele für die Materialien eines anorganischen Konverters 1 sind oder umfassen eine Glaskeramik, PiG (Phosphor in Glas) und/oder keramisiertes Glas. Der Ring 3 ist, wie vorstehend bereits ausgeführt, vorzugsweise ein Metallring 3. Beispiele für die Materialien des Metallrings 3 sind oder umfassen NiFeCo Legierungen, NiFe Legierungen und/oder vorzugsweise ferritische Edelstähle. Das Material oder Glas der Optik ist vorzugsweise an die Eigenschaften des Konverters angepasst. Die Gläser besitzen einen Brechungsindex in einem Bereich von etwa 1,4 bis etwa 2. Geeignete Materialien oder Gläser für die Optiken 2 können sein: Gläser mit hoher IR-Transmission, da diese für Wärmestrahlung transparent sind und/oder Gläser mit angepasstem Wärmeausdehnungskoeffizient (CTE), um eine Spannungsreduzierung gegenüber dem Konverter 1 und dem Metallring 3 zu erreichen und/oder transparente Gläser mit angepasstem Brechungsindex an den Konverter 1, um die Auskopplungseffizienzen zu erhöhen und/oder Gläser mit niedrigem T_{G}, die im Wesentlichen unter dem T_{G} des Konverters 1 liegen. Vorzugsweise liegt das T_{G} der Gläser etwa 50 °C bis etwa 300 °C unter dem T_{G} des Konverters 1. Geeignete Gläser sind z. B. Gläser mit einem niedrigen T_{G}, wie die Schott-Gläser 8250, T-SK57, T-LASF47. Ungeeignete Gläser sind z. B. P-SF67, da Farbveränderungen und/oder Trübungen auftreten können. Das Aufbringen oder Abscheiden einer Beschichtung 4 ist in den nachfolgenden Figuren nicht dargestellt. Ein Beispiel für eine solche Beschichtung 4 ist eine Galvanikbeschichtung 4. Eine konkrete Ausführung ist ein SnAgCu-Lot. Sofern eine Beschichtung 4 auf den Metallring 3 aufgebracht werden soll, ist in manchen Fällen eine Vorbehandlung des Metallrings 3 erforderlich. Ein Beispiel für eine Vorbehandlung ist ein Beizprozess. Dieser kann z. B. mittels einer HF- und/oder HCl-Säure erfolgen. Somit ist das Optik-Konverter-System 100 in einer bevorzugten Ausführungsform ein anorganisches Optik-Konverter-System 100.

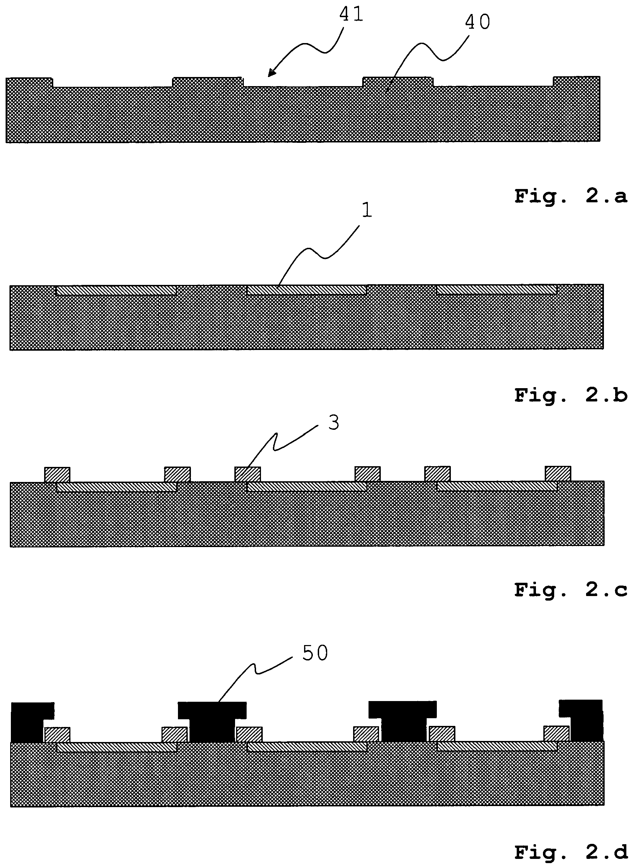

Die erfindungsgemäßen Optik-Konverter-Systeme 100 können einzeln hergestellt werden. Bevorzugt wird jedoch eine Vielzahl an Optik-Konverter-Systemen 100 gleichzeitig hergestellt. Hierzu werden die dazu erforderlichen Bauteile 1, 2, 3 und/oder 4 z. B. jeweils oder zumindest teilweise in einer Art Matrix 40 oder Array 40 oder Zeile 40 angeordnet oder bereitgestellt. Eine Matrix 40 kann vorzugsweise etwa 50 bis zu etwa 20.000 Positionen enthalten. Die Figuren 2a bis 11.d zeigen schematisch verschiedene Ausführungsformen des erfindungsgemäßen Verfahrens zur Herstellung des Optik-Konverter-Systems 100. Die Herstellung erfolgt jeweils in einer Matrix 40. Die hierzu erforderlichen Bauteile sind in einem Querschnitt dargestellt.

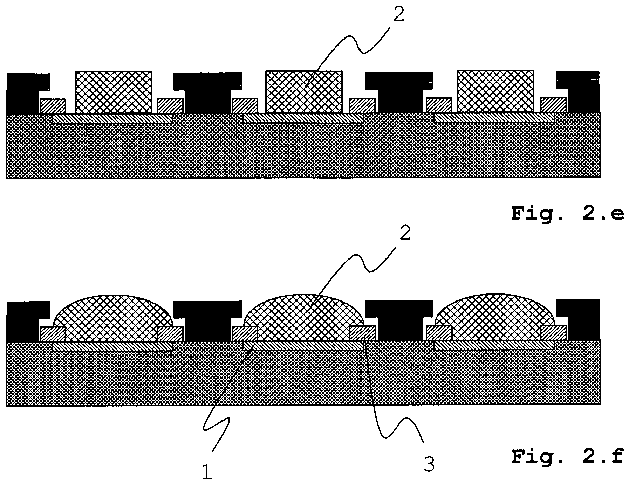

Die Figuren 2.a bis 2.f zeigen eine erste beispielhafte Ausgestaltung des erfindungsgemäßen Verfahrens. Zunächst wird ein Träger 40 bereitgestellt, in dessen Oberseite eine Vielzahl an Aussparungen 41 eingebracht ist (Figur 2.a). Da eine Vielzahl an Aussparungen 41 eingebracht ist, wird der Träger 40 auch als Array 40 bezeichnet. Der Träger 40 ist eine vorzugsweise konditionierte Graphitform. In einem nachfolgenden Verfahrensschritt werden nun die Konverter 1 oder Konverterplättchen 1 auf der Oberseite des Trägers 40 bzw. in den Aussparungen 41 positioniert (Figur 2.b). In einem nachfolgenden Schritt werden nun die Metallringe 3 auf der Oberseite des Trägers 40 positioniert, zum Beispiel durch ein einfaches Aufsetzen (Figur 2.c). Die Positionierung der Konverter 1, der Ringe 3 und/oder der Glasposten 2, aus welchen die Optiken 2 gebildet werden, kann hierbei durch sogenannte Begrenzer 50 oder Barrieren 50 unterstützt werden (Figur 2.d). Diese Barrieren 50 dienen zum einen als Aufschmelzbarrieren, so dass die in den nachfolgenden Verfahrensschritten aufgebrachten Glasrohlinge 2 definiert aufgeschmolzen werden können. Die Barrieren 50 können auch als Zentrierhilfen verwendet und daher auch als Justage-Pins 50 bezeichnet werden. Die Barrieren 50 können z. B. als eine Platte 50, vorzugsweise eine Graphitplatte 50, bereitgestellt werden, welche direkt über der Oberseite des Trägers 40 positioniert wird. In einem nachfolgenden Verfahrensschritt werden die Glasposten 2, welche auch als Glasabschnitte 2 bezeichnet werden, auf der Oberseite des Trägers 40, im Detail auf den Konvertern 1, positioniert (Figur 2.e). Die Positionierung der Glasposten 2 erfolgt beispielhaft ebenso über einen Aufsetzprozess, wie "Pick-and-Place". Die Glasposten 2 können z. B. als Kugeln und/oder als Stababschnitte bereitgestellt werden. In einem nächsten Schritt werden die Glasposten 2 aufgeschmolzen (Figur 2.f). Hierzu werden die Glasposten 2 auf eine Temperatur von etwa 600 bis etwa 1000°C erwärmt. Die Glasabschnitte 2 werden niedrig viskos und verlaufen. Es erfolgt jeweils eine Verbindung des Glaspostens 2 mit dem Metallring 3 und dem Konverter 1. Es ist eine stoffschlüssige Verbindung. Die Barrieren 50 und/oder die Ringe 3 bilden eine Grenze für das Kollabieren oder Zerfließen der Glasposten 2, so dass sich aufgrund der Oberflächenspannung eine im Wesentlichen definierte Konvexlinse als Optik 2 ausbildet. Dies erfolgt insbesondere bei einer Viskosität in einem Bereich von etwa 10⁴ dPas bis 10⁶ dPas. Das Aufschmelzen erfolgt typischerweise für eine Zeitdauer von etwa 1 bis 15 min. Beim Aufschmelzen erfolgt das Ausbilden der Optik 2 und das Verbinden der Optik 2 mit dem Konverter 1 im Wesentlichen gleichzeitig.

Abschließend erfolgt eine Inspektion der einzelnen Optik-Konverter-Systeme 100. Abschließend werden diese dann in ein entsprechendes Gehäuse 200 eingebaut. Hierzu sei jedoch auf die Ausführungen zu den Figuren 12.a bis 12.d verwiesen. Das Vereinzeln der einzelnen Optik-Konverter-Systeme 100 bzw. das Herauslösen aus dem Träger 40 ist in den Figuren nicht dargestellt. Da die Bauteile 100 in dem vorliegenden Beispiel nur in den Aussparungen 41 des Trägers 40 bzw. auf der Oberseite des Trägers gelagert bzw. aufgelegt sind, können diese einfach entnommen werden. Die Entnahme der Optik-Konverter-Systeme 100 ist jedoch nicht zwingend. Eine Vielzahl von gebildeten Optik-Konverter-Systemen 100 kann auch in einer Matrix an einen Kunden geliefert werden.

Um eine Beeinträchtigung der Eigenschaften der Optik 2 beim Einschmelzen zumindest zu vermindern, kann das Aufschmelzen in einer definierten Atmosphäre erfolgen. Beispiele für eine solche definierte Atmosphäre sind Stickstoff und/oder Wasserstoff und/oder Argon. Zur Verbesserung der Glasoberfläche der Optik 2, hier der Glasoptik, kann noch eine Feuerpolitur der Oberseite 2a der Optik 2 erfolgen.

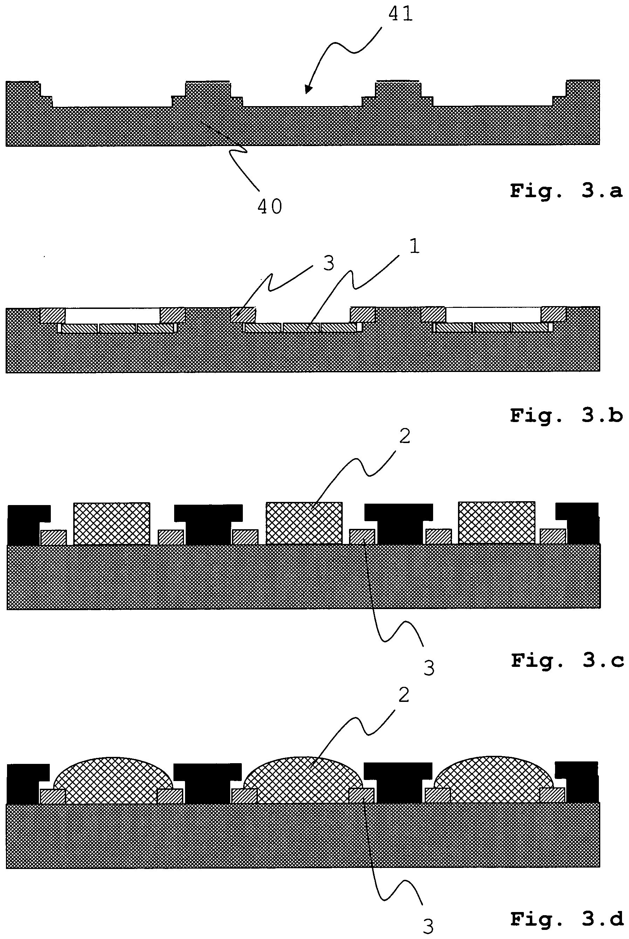

Die Figuren 3.a und 3.b zeigen eine Variante des vorstehend illustrierten Verfahrens. Es ist ein Verfahren beschrieben, bei welchem die Aussparungen 41 in der Oberseite des Trägers 40 derart ausgestaltet sind, dass sowohl der Konverter 1 als auch der dazu gehörige Metallring 3 in der Aussparung 41 angeordnet werden. Sowohl das Positionieren der Konverter 1 als auch der Metallringe 3 erfolgt vorzugsweise jeweils über einen "Pick-and-Place-Prozess". Dies ist im Unterschied zu den Figuren 2.c und 2.d, in denen der Metallring 3 sich auf der Oberfläche des Trägers 40 und der Konverter 1 sich in der Aussparung 41 befindet. Es ist natürlich auch denkbar, dass sowohl Konverter 1 als auch Metallring 3 auf der Oberfläche des Trägers 40 positioniert werden. Die Positionierung könnte in einem solchen Fall über die vorstehend beschriebenen Barrieren 50 erfolgen. Zudem sind vorliegend die Konverter 1 aus kleineren Konvertereinheiten 1 zusammengesetzt. Der Verbindung der einzelnen Konvertereinheiten 1 zu einem Konverter 1 erfolgt über den Verbund mit der aufzuschmelzenden Optik 2.

Die Figuren 3.c und 3.d zeigen eine weitere Variante des Verfahrens, in der nur der Metallrahmen 3 auf der Oberseite des Trägers 40 positioniert wird. Die Glasabschnitte 2 werden positioniert und es erfolgt ein Aufschmelzen der Glasabschnitte 2 in dem Metallrahmen 3. Der gebildete Verbund wird dem Träger 40 entnommen. Nachträglich erfolgt ein Planschleifen und/oder Polieren der Rückseite 2b der gebildeten Optik 2. Abschließend wird der Verbund über die abgeschliffene Rückseite 2b der Optik 2 mit einem Konverter 1 verbunden. Das Verbinden des Verbundes mit dem Konverter 1, hier mit der Vorderseite 1a des Konverters 1, erfolgt erfindungsgemäß über Sintern, und in anderen, nicht erfindungsgemäßen Beispielen über ein Bonden, Aufdrucken, Dispensen und/oder Laminieren des Konverters 1 auf die bearbeitete Rückseite 2b der Optik 2 bzw. des Verbundes.

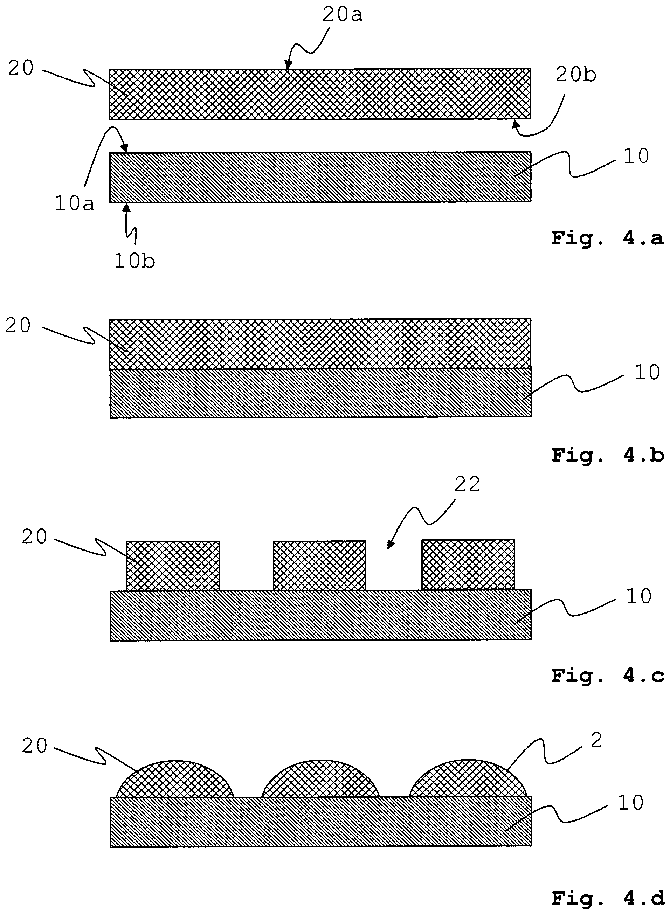

Eine weitere Ausführungsform des erfindungsgemäßen Verfahrens ist in den Figuren 4.a bis 4.d beschrieben. In einem ersten Schritt werden eine Glasplatte 20 und ein Konverter 1 oder eine Konverterplatte 10 gegenüberliegend positioniert (Figur 4.a). Es erfolgt ein Aufsintern der Glasplatte 20 auf die Konverterplatte 10 (Figur 4.b). Dies erfolgt bei einer Temperatur, welche knapp über dem T_{G} des Glases der Glasplatte 20 liegt. Daraufhin erfolgt ein Strukturieren der Glasplatte (Figur 4.c). Das Strukturieren ist derart, dass Aussparungen 22 oder Durchgänge 22 der Glasplatte 20 ausgebildet werden. Hierbei werden einzelne Glasposten 2 auf der Oberseite der Konverterplatte 10 gebildet, aus denen später die Optiken 2 geformt werden. Die Strukturierung kann mittels RIE ("Reactive Ion Etching") und/oder Sandstrahlen und/oder Nassätzen und/oder Ultraschallschwingläppen und/oder Sägen erfolgen. Die Strukturierung erfolgt vorzugsweise über einen Lithographieverfahren. Zur Strukturierung, insbesondere mittels RIE, wird im Allgemeinen eine Art Maske auf der Oberseite 20a der Glasplatte 20 aufgebracht, welche dann nach der Strukturierung wieder entfernt wird, welches in den vorliegenden Figuren jedoch nicht dargestellt ist. Nach dem Strukturieren erfolgt ein Aufschmelzen des Glasabschnitte 2 (Figur 4.d). Beim definierten Aufschmelzen des Glases bildet sich wiederum eine sogenannte Halbkugellinse als Optik 2 aus. Das Aufschmelzen des Glases erfolgt in einem Temperaturbereich von etwa 100 bis 140°C, vorzugsweise von etwa 120°C, über T_{G} des Glases. Für das Glas T-SK57 ergibt sich hierbei eine Temperatur von 625°C. Die Dauer des Aufschmelzens liegt in einem Bereich von etwa 15 min bis etwa 25 min, vorzugsweise von etwa 20 min. Das Vereinzeln der Optik-Konverter-Systeme 100 erfolgt zum Beispiel mittels Schneiden oder Läppen. Ist ein entsprechend großes Bauteil erforderlich, kann es auch direkt verwendet werden.

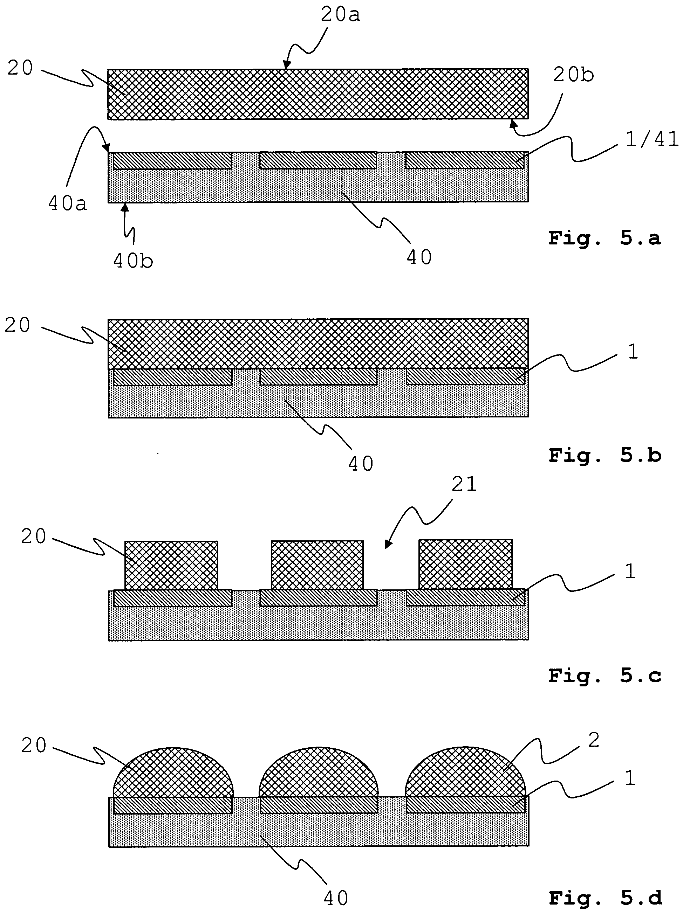

Die Figuren 5.a bis 5.d zeigen eine Variante des Prozesses, bei dem eine Glasplatte 20 strukturiert wird. Hierbei wird ein Träger 40 bereitgestellt, in welchem Aussparungen 41 eingebracht sind und in denen die Konverterplättchen 1 oder Konverter 1 positionierbar sind (Figur 5.a). Es erfolgt ein Aufsintern der Glasplatte 20 auf die Konverter 1 und vorzugsweise auch auf den Träger 40 (Figur 5.b), ein Strukturieren der Glasplatte 20 (Figur 5.c) und ein Aufschmelzen der durch das Strukturieren gebildeten Glasposten 2 (Figur 5.d). Für weitere Details sei auf die Ausführungen zu den Figuren 4.a bis 4.d verwiesen. Das Ausbilden der Optiken 2 ist hier jedoch definierter, da durch die Kanten der Konverter 1 bzw. der Aussparungen 41 eine Art Barriere 50 für das Kollabieren der Glasposten 2 gebildet wird.

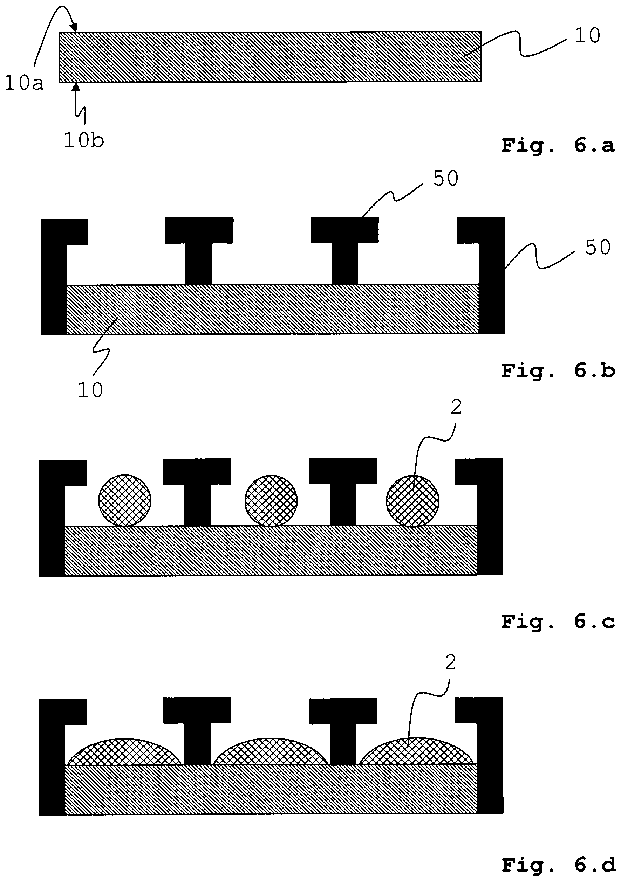

Die Figuren 6.a bis 6.d zeigen eine nächste Ausführungsform des erfindungsgemäßen Verfahrens. Zunächst wird wiederum eine Konverterplatte 10 bereitgestellt (Figur 6.a). Die Konverterplatte 10 wird mit einer Fixierung 50 oder Barriere 50 und den Glasposten 2 bestückt (Figur 6.b bzw. Figur 6.c). Die Glasposten 2 können z. B. als Glaskugeln 2 bereitgestellt werden. Mittels der Barriere 50 wird eine Barriere zum Aufschmelzen der Glasrohlinge 2 definiert. Die Barriere 50 ist vorzugsweise aus Graphit gebildet. Das Aufschmelzen ist in Figur 6.d dargestellt. Das Aufschmelzen erfolgt analog zu dem in Figur 5.d dargestellten Aufschmelzen.

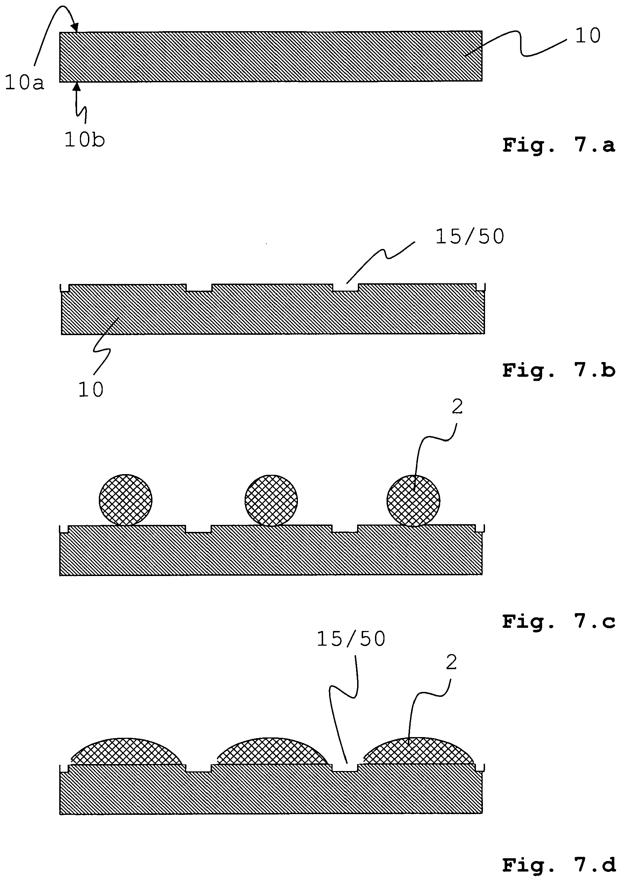

Die Figuren 7.a bis 7.d zeigen eine Abwandlung des in den Figuren 6.a bis 6.d dargestellten Verfahrens. Hierbei wird die Barriere 50 oder Begrenzung 50 zum Aufschmelzen durch eine Strukturierung 15 der Oberseite 10a des Konverters 1 oder der Konverterplatte 10 gebildet oder definiert. Die Barriere 50 oder Strukturierung 50 kann hierbei durch eine subtraktive Struktur 15, wie eine Ausnehmung 15, oder durch eine additive Struktur, wie ein aufgebrachte Schicht 15, oder durch eine Kombination aus beidem bereitgestellt sein. Die Strukturierung 50 ist vorliegend beispielhaft als Ausnehmung 15 oder Aussparung 15 in der Oberseite 10a der Konverterplatte 10 ausgebildet. Das Strukturieren erfolgt beispielsweise über Sintern, RIE, Sägen und/oder einen Beschichtungs-/Lithographie-Prozess. Das Bereitstellen einer Barriere 50 kann auch durch eine Kombination von Bereitstellen einer Barriere 50 und Strukturieren, vorzugsweise der Oberseite 1a, des Konverters 1 erfolgen.

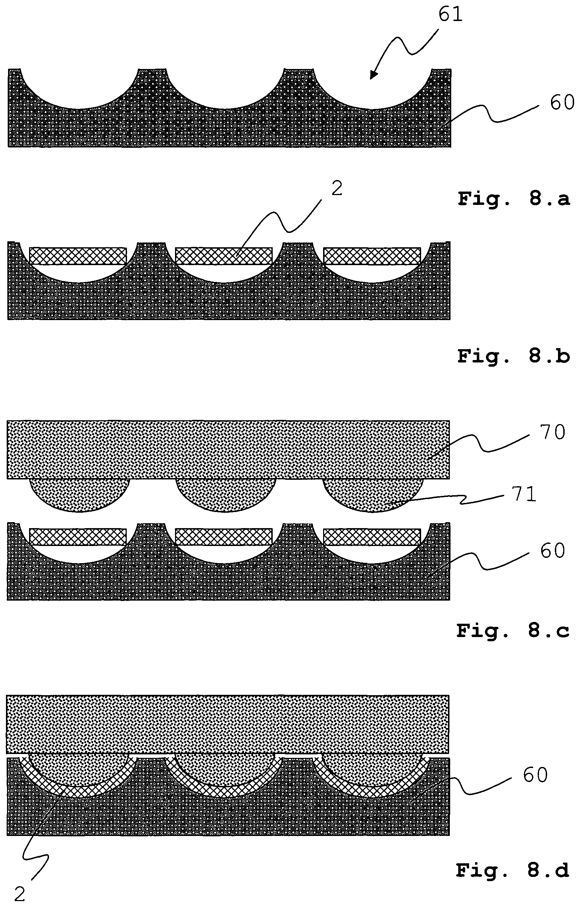

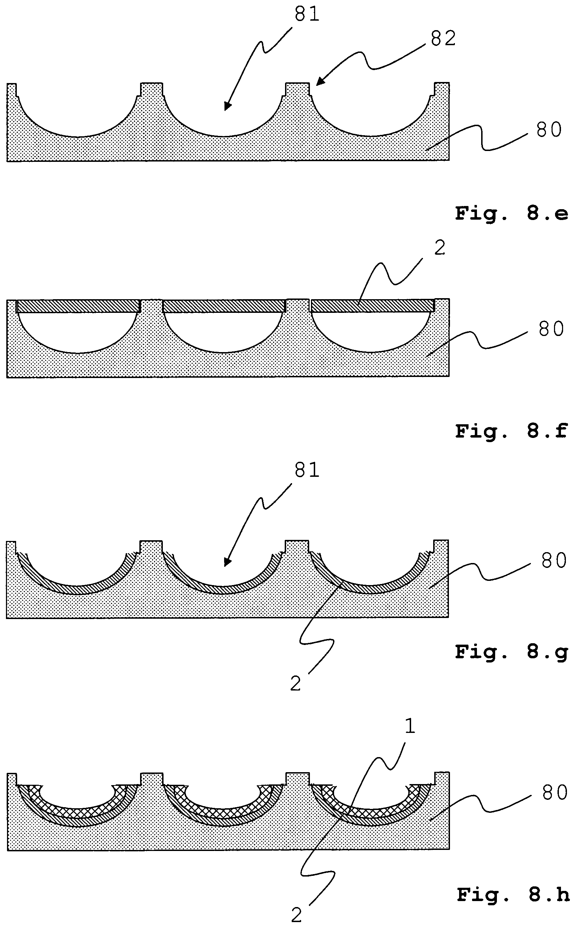

In den Figuren 8.a bis 8.h ist eine weitere Ausgestaltung des erfindungsgemäßen Verfahrens illustriert. Zunächst wird eine Form 60, vorzugsweise eine Graphitform, bereitgestellt (Figur 8.a). In der einen Seite der Form 60 ist eine Vielzahl an Ausnehmungen 61 eingebracht. Die Form und die Abmessungen der einzelnen Ausnehmungen 61 oder Aussparungen 61 sind an das zu bildende Optik-Konverter-System 100 angepasst. Die Ausnehmungen 61 stellen eine Negativform für das zu bildende Optik-Konverter-System 100, hier die zu bildende Optik 2, dar. Um einen gewünschten Linseneffekt zu erzeugen, wird die Linsenform über die Geometrie der Graphitformen 61 oder Aussparungen 61 eingestellt. Das Bereitstellen der Optik 2 erfolgt über einen sogenannten Blankpressprozess. Die Form 60 wird in seinen Aussparungen 61 mit den Glasposten 2 bestückt (Figur 8.b). Mittels einer zweiten oberen Form 70, vorzugsweise ausgebildet als Graphitform, wird nun der Glasposten 2 zwischen der unteren Form 60 und der oberen Form 70 blankgepresst (Figuren 8.c und 8.d). Dies erfolgt bei einer Temperatur, welche vorzugsweise in einem Bereich von etwa 50 bis etwa 90°C über dem T_{G} des Glases liegt.

In den Figuren 8.e bis 8.g ist das Bereitstellen des Konverters 1 oder der Konverter 1 beschrieben. Zunächst wird wiederum eine Form 80 bereitgestellt. In der Oberseite der Form 80 sind entsprechende Aussparungen 81 eingebracht. Die Aussparungen 81 sind an die Form und die Abmessungen des zu bildenden Optik-Konverter-Systems 100 oder des Konverters 1 angepasst. Die Aussparungen 81 stellen eine Negativform des zu bildenden Optik-Konverter-Systems 100, insbesondere des Konverters 1, dar. In der Oberseite der jeweiligen Aussparung 81 ist optional eine Art Nut 82 eingebracht. Durch diese Nut 82 erfolgt ein Positionieren der Konverter 1. Die Konverter 1 besitzen vorzugsweise eine konstante Dicke wegen der zu erzeugenden Farbortstabilität. Die Konverter 1 werden nun erwärmt. Die Erwärmung erfolgt auf eine Temperatur in einem Bereich von etwa 400 bis 800 °C. Die Konverter 1 kollabieren, sacken in die Aussparung 81 ein und passen sich im Wesentlichen der Form der Aussparung 81 an.

In Figur 8.h ist das Zusammenführen der beiden vorgeformten Komponenten, der Optik 2 und des Konverters 1 illustriert.

Über einen Verbindungsprozess, wie z. B. Sol-Gel-Bonding und/oder Diffusionsbonding, werden die beiden Komponenten 1 und 2 jeweils miteinander verbunden.

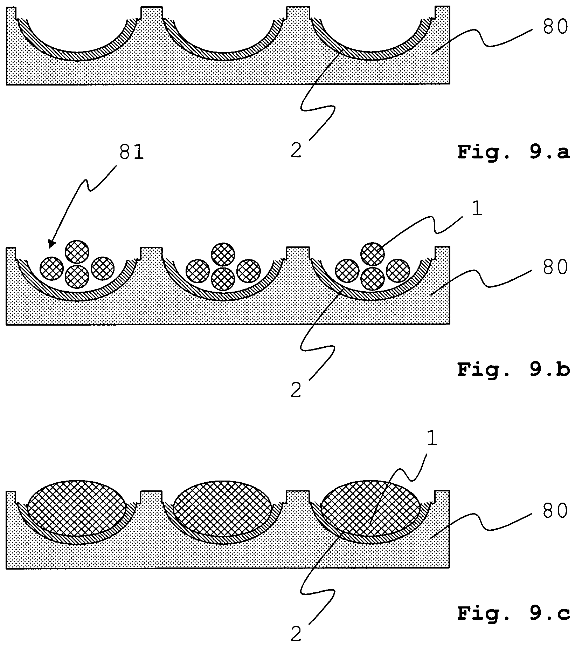

In den Figuren 9.a bis 9.c ist eine Variante des vorstehend beschriebenen Durchsackprozesses dargestellt. Es erfolgt zunächst ein Bereitstellen und Erwärmen der Konverterplättchen 1 in einer Form (Figur 9.a), wie dies bereits in den Figuren 8.e bis 8.g illustriert ist. Nachdem die Konverter 1 geformt oder gebildet sind, werden nun die Optiken 2, vorzugsweise Linsen 2, über einen Reflow-Prozess aufgebracht. Dies ist in den Figuren 9.b und 9.c illustriert. Zunächst werden die Glasposten 2, vorliegend ausgebildet als kleine Kügelchen, in den Aussparungen 81 bereitgestellt. Über ein Erwärmen und Aufschmelzen der Glasposten 2 bildet sich eine Verbindung zwischen den einzelnen Konvertern 1 und dem jeweiligen Glasposten 2 aus. Gleichzeitig bildet oder formt sich die Linse 2 bzw. die Optik 2.

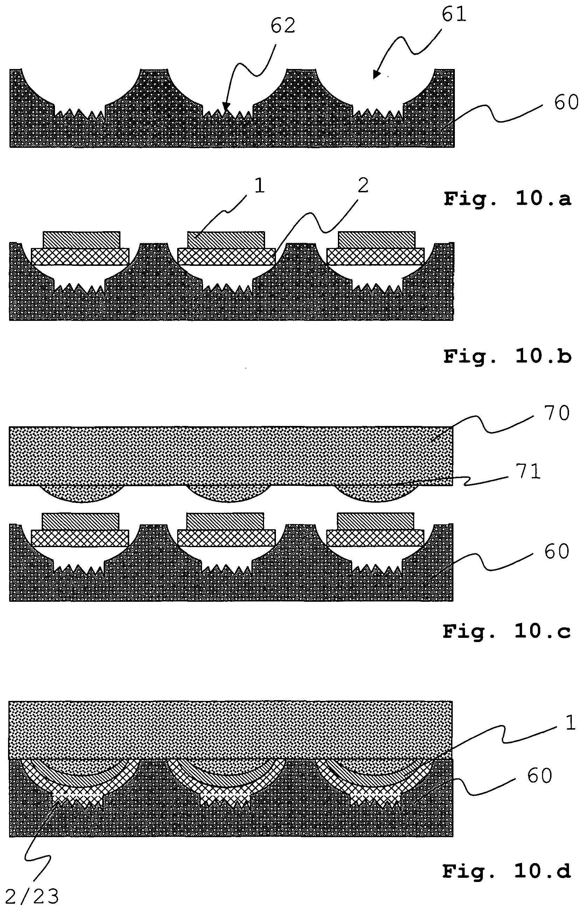

Die Figuren 10.a bis 10.d zeigen eine weitere Variante des erfindungsgemäßen Verfahrens. Hierbei wird das Optik-Konverter-System 100 über einen Blankpressprozess hergestellt. Dazu werden sowohl die Glasposten 2 als auch die Konverter 1 jeweils in einer Aussparung 61 der Form 60 bereitgestellt. Das Ausbilden des Optik-Konverter-Systems 100 bzw. das Ausbilden der Gestalt des Optik-Konverter-Systems 100 erfolgt hier über das Zusammenführen der Form 60 mit der Form 70. Um zusätzlich noch eine DOE-Struktur 23 oder Mikrooptikstruktur 23 in die Optik 2 einzubringen, im Detail in die Oberseite 2a der Optik 2 einzubringen, sind in den Boden der Aussparungen 61 entsprechende Strukturen 62 eingebracht oder angeordnet. Die dargestellte Zackenform illustriert die entsprechende Struktur. Die Strukturen 62 stellen eine Negativform der auf der Oberseite 2a der Optik 2 zu bildenden Strukturen 23 dar. Es erfolgt somit wieder das Bestücken einer Heißpresse mit einer Pressform 60 und 70, dem Konvertersubstrat 1 und dem Glasposten 2 aus einem niedrigen T_{G}-Glas. Es erfolgt sozusagen ein Prägen der Strukturen 62 in das Glas oder in die Optik 2. Für ein Glas P-SK57 ergeben sich die folgenden Verfahrensparameter: Bei einer Temperatur von 530 bis 590 °C, vorzugsweise um etwa 560°C, erfolgt ein Drücken mit etwa 10 bis 50 kg/cm², insbesondere für eine Dauer von etwa 1 bis 3 min.

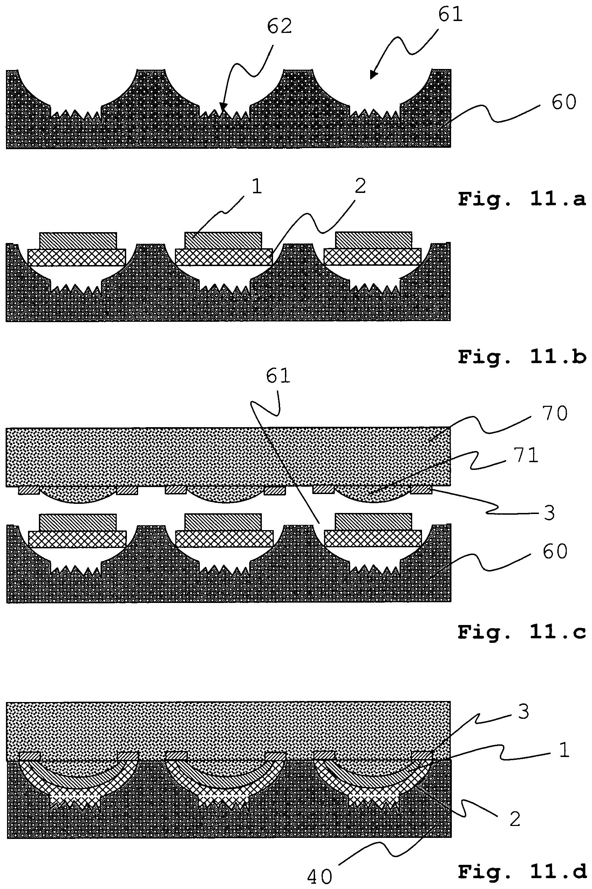

Die mit den vorstehend beschriebenen Verfahren hergestellten Optik-Konverter-Systeme 100 können selbstverständlich mit oder ohne einen Metallring 3 ausgestattet werden, auch wenn dies in den einzelnen Figuren nicht im Einzelnen dargestellt ist. Sofern ein Metallring 3 verwendet wird, kann selbstverständlich auch eine Metallisierung des Metallrings 3 erfolgen. Die Figuren 11.a bis 11.d illustrieren hierzu noch einmal das Verfahren, welches in den Figuren 10.a bis 10.d beschrieben ist, unter Verwendung von Metallringen 3. Die Metallringe 3 werden zum Beispiel durch die Form 70 bereitgestellt. Sie können auch in den gebildeten Räumen positioniert werden.

Die Figuren 12.a bis 12.d illustrieren die Verwendung der durch das erfindungsgemäße Verfahren hergestellten Optik-Konverter-Systeme 100 in einem Package 200 oder Gehäuse 200. Es wird ein Gesamtsystem 300 oder ein LED-Package 300 gebildet. Das Optik-Konverter-System 200 dient sozusagen als eine Art Abdeckung für das Gehäuse 200. Das Package 200 kann ein GTMS-Package ("Glass To Metal Seal"), Si-Package, ein Plastik-Package und/oder ein Keramik-Package sein.

Die Figuren 12.a und 12.d illustrieren den Querschnitt eines Gehäuses 200. Es ist jeweils ein dreilagiges Gehäuse 200. Es besteht aus einem oder umfasst einen Verbund aus einem Basisteil 201, einer ersten Glasschicht 202, zwei Anschlussteilen 203, eine zweite Glasschicht 204 und ein Kopfteil 205. In dem Inneren des Gehäuses 200 ist eine LED 260 angeordnet. Die LED 260 oder der LED-Chip 260 ist auf einem Montagebereich 212 angeordnet. Die LED 260 ist über Drähte 273 mit den Anschlussteilen 203 und 204 verbunden. Oberhalb der LED 260 befindet sich der sogenannte Durchgangsbereich 261 für die Strahlung oder das Licht, welches von der LED 260 emittiert wird. Die Oberseite des Durchgangsbereichs 261 ist mit einem Optik-Konverter-System 100 verschlossen. Vorzugsweise ist der Durchgangsbereich 261 und somit das Package 200 durch den Deckel 100 hermetisch verschlossen. Dies kann z. B. über ein Verlöten des Optik-Konverter-Systems 100 mit dem Kopfteil 205 oder der Oberseite 200a des Gehäuses 200, welches bzw. welche aus einem Metall bereitgestellt wird, erfolgen.

Die LED 260 ist zum Beispiel eine blau emittierende LED und der Konverter 1 ein Glas, das einen Lumineszenzfarbstoff, wie sogenannten gelben Phosphor, enthält. Das kurzwellige blaue Licht regt den Farbstoff zum Leuchten an. Dieser Effekt wird als Photolumineszenz bezeichnet. Dabei wird ein langwelligeres gelbes Licht abgegeben. Im Allgemeinen wird nicht das gesamte blaue Licht umgewandelt. Somit resultiert aus einer additiven Farbmischung der beiden Spektralfarben blau und gelb das weiße Licht. Die Konversion von blau nach gelb kann auch durch ein keramisiertes Glas erfolgen. In einem weiteren Beispiel ist die LED 260 eine UV-Licht emittierende LED und der Konverter 1 ein Glas, das mehrere Lumineszenzfarbstoffe, wie sogenannten roten, grünen und blauen (RGB) Phosphor, enthält. Das kurzwellige UV-Licht regt die Farbstoffe zum Leuchten an. Dabei wird rotes, grünes und blaues Licht abgegeben. Somit resultiert aus einer additiven Farbmischung das weiße Licht. Zur Erhöhung der CRI-Werte kann auch ein Konverter 1 mit einer RGB-LED 260 kombiniert werden. Optional kann zusätzlich jeweils noch zumindest eine rote LED 260 und/oder eine grüne LED 260 verwendet werden, was in den Figuren jedoch nicht dargestellt ist. Dadurch kann der Farbort verändert und das Licht durchgestimmt werden.

Figur 12.a zeigt eine Ausführungsform, in der das System 100 "einfach" auf das Gehäuse 200 aufgesetzt wird. Die drei oberhalb der LED 260 eingezeichneten Pfeile illustrieren die Emissionsrichtung der von der LED 260 emittierten Strahlung. Figur 12.b zeigt eine Ausführungsform, bei der als Optik 2 ein Konzentrator 24 oder eine sogenannte "Light-Pipe" 24 auf dem Konverter 1 angeordnet ist. Zum einen wirken die Innenseiten des Konzentrators 24 als Reflektor. Zum anderen wirken die Wände auch als eine Art Lichtleiter für das Licht, welches seitlich von dem Konverter 1 abgestrahlt wird. Mittels des Konzentrator 24 kann die Auskopplungseffizienz des Gesamtsystems 300 erhöht werden. Zusätzlich ist noch eine zweite Optik 2, ausgebildet als Linse 25 auf dem Konzentrator 23 angeordnet.

Zusätzlich kann noch eine Optik 21 unterhalb des Konverters 1, vorzugsweise direkt auf der Unterseite 1b des Konverters 1, angeordnet sein. Über eine solche Optik 21 kann ein Bündeln des aus der LED 260 kommenden Lichts bzw. der aus der LED 260 kommenden Lichtstrahlung erfolgen. Dies ist in Figur 12.c dargestellt.

Die Figur 12.a bis 12.c zeigen jeweils eine Anwendung der vorliegenden Erfindung, in der das System 100 beabstandet zur LED 260 angeordnet ist. Figur 12.d zeigt eine Ausgestaltung, in welcher der Konverter 1 auf der LED 260 aufsitzt oder angrenzend zur LED 260 positioniert ist. Der Durchgangsbereich 261 ist hierbei im Wesentlichen vollständig durch den Konverter 1 ausgefüllt.

Das vorliegende System 100 ist vorzugsweise ein anorganisches System 100. Das System 100 besteht, vorzugsweise zumindest, aus einem Konverter 1 und/oder einer Optik 2 und/oder einem Metallträger 3. Der Metallträger 3 kann, wie vorstehend beschrieben, als Ring 3 oder als Kappe 3 ausgebildet sein. Das System 100 kann unter anderem als Package-Deckel oder als Package-Abschluss verwendet werden. Das Design des Verfahrens ist massenfertigungstauglich. Dies ist möglich aufgrund der zu beherrschenden Prozesse, wie Aufschmelzen, Durchsacken, Sintern, Prägen usw.. Die Temperaturbeständigkeit, aber auch die Temperaturwechselbeständigkeit eines durch das erfindungsgemäße Verfahren hergestellten Optik-Konverter-Systems 100 liegt deutlich über der Temperaturbeständigkeit der bekannten Systeme. Ohne einen Metallring 3 läßt sich für das System 100 eine Temperaturbeständigkeit von bis zu etwa 400°C erzielen. Mit einem Metallring 3 und für ein z.B. Snhaltiges Lot weist das System 100 eine Beständigkeit von bis zu etwa 350°C auf. Zudem sind die bevorzugten Komponenten des Systems UV- und chemisch beständig oder im Wesentlichen UV- und chemisch beständig. Sofern das Optik-Konverter-System 100 als Package-Deckel verwendet wird, kann dieses luft- und/oder feuchtigkeitsdicht auf einem Package 200 befestigt werden. Da bevorzugt zudem im Wesentlichen nur anorganische Komponenten verwendet werden, erfolgt kein Ausgasen der Komponenten, z.B. in Form von Kohlenwasserstoffen. Es kann somit eine organische Kontamination der LED 260 im Wesentlichen vermieden werden. Das Package 200 kann ausgeheizt und sogar mit Inertgas gefüllt und verschlossen werden.

Es ist dem Fachmann ersichtlich, dass die beschriebenen Ausführungsformen beispielhaft zu verstehen sind. Die Erfindung ist nicht auf diese beschränkt, sondern kann in vielfältiger Weise variiert werden, ohne die in Anspruch 1 definierte Erfindung zu verlassen.

### Bezugszeichenliste

- 1: Konverter
- 1a: Oberseite des Konverters
- 1b: Unterseite des Konverters

- 2: Optisches Bauelement oder Optik oder Glasposten oder Glasabschnitt
- 2a: Oberseite des optisches Bauelements
- 2b: Unterseite des optisches Bauelements

- 3: Ring oder Metallring oder Metallträger
- 4: Beschichtung oder Auskleidung
- 5: Mittel zur Wärmeabfuhr

- 10: Konverterplatte
- 10a: Oberseite der Konverterplatte
- 10b: Unterseite der Konverterplatte

- 11: Konverterschicht
- 12: Konverterschicht
- 13: Konverterschicht
- 14: Funktionsschicht oder Beschichtung
- 15: Strukturierung oder Aussparung oder Ausnehmung

- 20: Glasplatte
- 20a: Oberseite der Glasplatte
- 20b: Unterseite der Glasplatte

- 21: Optisches Bauelement oder Optik
- 22: Aussparungen oder Durchgänge
- 23: DOE-Struktur oder Mikrostruktur
- 24: Konzentrator
- 25: Linse

## Patentansprüche

1. Verfahren zur Herstellung einer Vielzahl von Konverterbausteinen (100) für die von zumindest einem opto-elektronischen Funktionselement (260) emittierte und/oder zu empfangende Strahlung, vorzugsweise von einer LED (260), umfassend
- Bereitstellen einer Vielzahl von anorganischen Konvertern (1) zur Konversion der emittierten und/oder zu empfangenden Strahlung,
- Bereitstellen einer Vielzahl von optischen Bauelementen (2),
wobei die Vielzahl der Konverter (1) und die Vielzahl der optischen Bauelemente (2) jeweils oder zumindest teilweise in einem Array bereitgestellt werden,
- Verbinden der Vielzahl der Konverter (1) und der Vielzahl der optischen Bauelemente (2) derart, dass die Vielzahl der Konverter (1) soweit erwärmt wird und/oder die Vielzahl der optischen Bauelemente (2) soweit erwärmt wird, dass die Vielzahl der Konverter (1) und die Vielzahl der optischen Bauelemente (2) aneinander haften und einen stoffschlüssigen Verbund bilden, so dass ein Array mit einer Vielzahl von Konverterbausteinen (100) bereitgestellt wird, wobei die anorganischen Konverter (1) eine Matrix aus anorganischem Material umfassen, in welche Leuchtstoffe eingebettet sind,
**dadurch gekennzeichnet, dass** das Verbinden der Konverter (1) und der optischen Bauelemente (2) über ein Sintern der Konverter (1) erfolgt.

2. Verfahren nach Anspruch 1 **dadurch gekennzeichnet,**
**dass**
die Konverter (1) und/oder die optischen Bauelemente (2) durch ein Pressen und insbesondere ein Erwärmen eines schüttfähigen Materials gebildet werden.

3. Verfahren nach dem vorstehenden Anspruch **dadurch gekennzeichnet,**
**dass** die optischen Bauelemente (2) als Glasposten (2) bereitgestellt werden, wobei
die Glasposten (2) insoweit erwärmt werden, dass das Glas eine Viskosität erreicht, bei der sich die optischen Bauelemente (2) ausbilden.

4. Verfahren nach dem vorstehenden Anspruch **dadurch gekennzeichnet,**
**dass** zumindest eine Begrenzung (50) zum definierten Aufschmelzen der Glasposten (2), bereitgestellt wird.

5. Verfahren nach einem der vorstehenden Ansprüche **dadurch gekennzeichnet,**
**dass** die Konverter (1) über einer Form (60) positioniert und insoweit erwärmt werden, dass das Material der Konverter (1) eine Viskosität erreicht, bei welcher die Konverter (1) in die Form (60) einsinken.

6. Verfahren nach einem der vorstehenden Ansprüche **dadurch gekennzeichnet,**
**dass** die Konverter (1) und/oder die optischen Bauelemente (2) durch Pressen, vorzugsweise durch Blankpressen, hergestellt werden.

7. Verfahren nach einem der vorstehenden Ansprüche **dadurch gekennzeichnet,**
**dass** wenigstens ein Ring (3), vorzugsweise ein Metallring (3), bereitgestellt wird, der sich zumindest abschnittsweise über den Umfang der Konverterbausteine (100) erstreckt.

## Claims

1. A method for producing a plurality of converter modules (100) for radiation emitted and/or to be received by at least one opto-electronic functional element (260), preferably from an LED (260), comprising:
- providing a plurality of inorganic converters (1) for converting the radiation emitted and/or to be received;
- providing a plurality of optical components (2);
wherein the plurality of converters (1) and the plurality of optical components (2) are provided in an array, each of them or at least part thereof;
- joining the plurality of converters (1) and the plurality of optical components (2) such that the plurality of converters (1) is heated to such an extent and/or the plurality of optical components (2) is heated to such an extent that the plurality of converters (1) and the plurality of optical components (2) adhere to each other and form a cohesive composite, so that an array with a plurality of converter modules (100) is provided;
wherein the inorganic converters (1) comprise a matrix of inorganic material with phosphors embedded therein;
**characterized in that** the joining of the converters (1) and the optical components (2) is effected by sintering of the converters (1).

2. The method according to claim 1,
**characterized in that** the converters (1) and/or the optical components (2) are formed by pressing and in particular by heating a free flowing material.

3. The method according to the preceding claim,
**characterized in that**
the optical components (2) are provided in the form of gobs (2), wherein
the gobs (2) are heated to such an extent that the glass reaches a viscosity at which the optical components (2) are being formed.

4. The method according to the preceding claim, **characterized in that** at least one boundary (50) is provided for melting the gobs (2) in predefined manner.

5. The method according to any one of the preceding claims, **characterized in that** the converters (1) are positioned over a mould (60) and heated to such an extent that the material of the converters (1) reaches a viscosity at which the converters (1) sink into the mould (60).

6. The method according to any one of the preceding claims, **characterized in that** the converters (1) and/or the optical components (2) are produced by pressing, preferably by blank pressing.

7. The method according to any one of the preceding claims, **characterized in that** at least one ring (3), preferably a metal ring (3), is provided, which extends about the periphery of the converter modules (100), at least in sections thereof.

## Revendications

1. Procédé de fabrication d'une pluralité de modules de convertisseurs (100) pour le rayonnement émis par au moins un élément fonctionnel optoélectronique (260) et/ou à recevoir de celui-ci, de préférence par une DEL (260), comportant :
- la fourniture d'une pluralité de convertisseurs anorganiques (1) pour la conversion du rayonnement émis et/ou à recevoir,
- la fourniture d'une pluralité de composants optiques (2),
où la pluralité des convertisseurs (1) et la pluralité des composants optiques (2) sont fournis respectivement ou au moins en partie dans un réseau,
- la connexion de la pluralité des convertisseurs (1) et de la pluralité des composants optiques (2), de telle manière que la pluralité des convertisseurs (1) sont chauffés et/ou que la pluralité des composants optiques (2) sont chauffés jusqu'à ce que la pluralité des convertisseurs (1) et la pluralité des composants optiques (2) adhèrent les uns aux autres et forment une liaison de matières, de sorte qu'un réseau présentant une pluralité de modules de convertisseurs (100) est fourni, dans lequel les convertisseurs anorganiques (1) comportent une matrice faite de matériau anorganique, dans laquelle des substances luminescentes sont incorporées,
**caractérisé en ce que** la connexion des convertisseurs (1) et des composants optiques (2) s'effectue par l'intermédiaire d'un frittage des convertisseurs (1).

2. Procédé selon la revendication 1, **caractérisé en ce que** les convertisseurs (1) et/ou les composants optiques (2) sont formés par un pressage et en particulier un chauffage d'un matériau coulant.

3. Procédé selon la revendication précédente, **caractérisé en ce que** les composants optiques (2) sont fournis sous la forme de paraisons (2), dans lequel
les paraisons (2) sont chauffées jusqu'à ce que le verre atteigne une viscosité à laquelle les composants optiques (2) se forment.

4. Procédé selon la revendication précédente, **caractérisé en ce qu'**au moins une limitation (50) est fournie pour la fusion définie des paraisons (2).

5. Procédé selon l'une quelconque des revendications précédentes, **caractérisé en ce que** les convertisseurs (1) sont positionnés au-dessus d'un moule (60) et chauffés jusqu'à ce que le matériau des convertisseurs (1) atteigne une viscosité à laquelle les convertisseurs (1) s'enfoncent dans le moule (60).

6. Procédé selon l'une quelconque des revendications précédentes, **caractérisé en ce que** les convertisseurs (1) et/ou les composants optiques (2) sont fabriqués par pressage, de préférence par pressage de précision.

7. Procédé selon l'une quelconque des revendications précédentes, **caractérisé en ce qu'**au moins une bague (3), de préférence une bague métallique (3), est fournie, qui s'étend au moins en partie sur la périphérie des modules de convertisseurs (100).
